(19) **Europäisches Patentamt**

**European Patent Office**

**Office européen des brevets**

(11) **EP 1 679 520 A1**

(12) **EUROPEAN PATENT APPLICATION**

(43) Date of publication:
**12.07.2006 Bulletin 2006/28**

(51) Int Cl.:
***G01R 31/04*** (2006.01)  ***G01N 21/956*** (2006.01)

(21) Application number: **06100242.4**

(22) Date of filing: **11.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **11.01.2005 JP 2005003724**
**06.12.2005 JP 2005352001**

(71) Applicant: **OMRON CORPORATION**
**Kyoto-shi, Kyoto 600-8530 (JP)**

(72) Inventors:
• **MORIYA, Toshihiro**
**600-8530, KYOTO (JP)**
• **WADA, Hirotaka**
**600-8530, KYOTO (JP)**
• **ONISHI, Takako**
**600-8530, KYOTO (JP)**
• **SHIMIZU, Atsushi**
**600-8530, KYOTO (JP)**
• **NAKAJIMA, Akira**
**600-8530, KYOTO (JP)**

(74) Representative: **Weihs, Bruno Konrad**
**Osha Liang**
**121, Avenue des Champs Elysées**
**75008 Paris (FR)**

(54) **Printed circuit board inspecting apparatus, inspection logic setting method, and inspection logic setting apparatus**

(57)     A technology is provided for automatically producing an inspection logic to be used in the action of inspecting a PC board. An inspection logic setting apparatus (2) is arranged for acquiring a plurality of first images of components to be detected by the inspection and a plurality of second images of components to be rejected by the inspection, dividing each of said plurality of first and second images into the plurality of blocks, calculating a color distance between said plurality of first images and said plurality of second images in said each block, selecting one or more blocks from said plurality of blocks which are relatively greater in the color distance, and assigning said selected block(s) to the area condition.

**EP 1 679 520 A1**

**Description**

BACKGROUND OF THE INVENTION

Technical Field

The present invention relates to a technology for producing an inspection logic for use in the inspection of surface mount PC boards.

Background Art

PC board inspecting apparatuses have been proposed for inspecting the quality of surface-mount soldering on printed circuitboards on which various electronic components are surface mounted. Solder fillets are known as "the bumps of solder between the electrodes of an electronic component and the lands on a printed circuit boards". However, such solder fillets may no be contacted to the electronic component while their appearance looks as if solder fillets are formed, depending of the wicking of the electrode portion of electronic component. It is therefore essential for judging the quality of soldering to accurately attain the shape of solder fillets consisting of free curve.

However, as a conventional PC board inspecting apparatus commonly employs a monochromatic light source (for emitting a single color of light), it may capture and analyze a three-dimensional image of solder fillets only with enormous difficulty. Such a conventional PC board inspecting apparatus will hardly be practical for examining whether the quality of soldering is good or not.

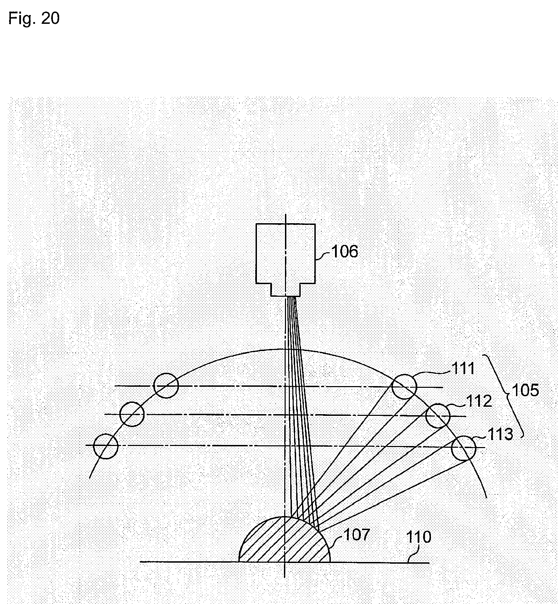

For solving the above drawback, we, the inventors, have proposed another PC board inspecting apparatus equipped with such a system as shown in Fig. 20 (See Citation 1) . The system is called three-color light source color highlight system (or simply referred to as a color highlight system) where solder fillets to be inspected are illuminated with the use of a multi-color light source for producing a three-dimensional quasi-color image of the solder fillets.

It is said that the action of inspecting printed circuit boards is automated in actual practice just after the introduction of such a color highlight system. In particular, the fillets of solder are hardly inspected by sight as electronic components have significantly been decreased in overall size. The board inspecting action will be conducted only using a PC board inspecting apparatus with the color highlight system.

Referring to Fig. 20, the color highlight system of the PC board inspecting apparatus comprises a light emitter 105 for emitting three primary colors of light which fall at different angles on an object to be inspected 107 placed on a board 110 and an imaging device 106 for receiving and imaging reflections of the colors from the object to be inspected 107. The light emitter 105 consists mainly of three annular light sources 111, 112, and 113 which are arranged in circles of different diameters and operated in response to control signals from a control processor for emitting three, red, green, and blue, colors of light at once. The light sources 111, 112, and 113 are positioned coaxially to surround the obj ect to be inspected 107 at the center for directing their respective lights at different angle to the object to be inspected 107.

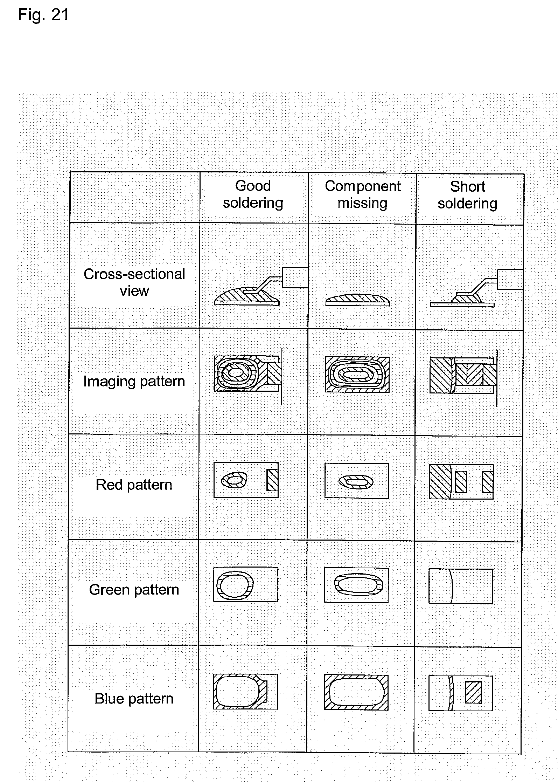

When each color of light emitted from the light emitter 105 is directedto the object to be inspected 107 (a solder fillet), its reflection determined by the angle of tilt at the surface of the object to be inspected 107 is received by the imaging device 106 . Accordingly, as shown in Fig 21, as the solder fillet to be inspected is duly shaped depending on the condition of soldering (good soldering, soldering with no component, or soldering failure), its image in a color pattern can exhibit any difference. This permits the solder fillet to be examined from its three-dimensional image without difficulty, hence contributing to the accurate action of examining whether or not an electronic component is placed at its position and whether or not the soldering is adequate.

The color highlight system of the PC board inspecting apparatus is designed for presetting the color condition indicative of "color of good board" and "color of not good board", extracting an area from the image to be inspected which satisfies the color condition, and determining the judgment through examining various feature values (for example, area size and length) in the extracted area. It is hence essential to predetermine the color condition to be utilized for the inspection and the judgment condition for discriminating between good and not good prior to the action of inspection. The color condition and the judgment condition act as parameters of the inspection logic. The setting and modifying the inspection logic is called teaching.

It is necessary for improving the accuracy of the inspection to have the color condition adapted for producing a significant and explicit difference between the feature value of a good board and the feature value of a not good board. In other words, the inspection accuracy largely depends on the teaching of the color condition.

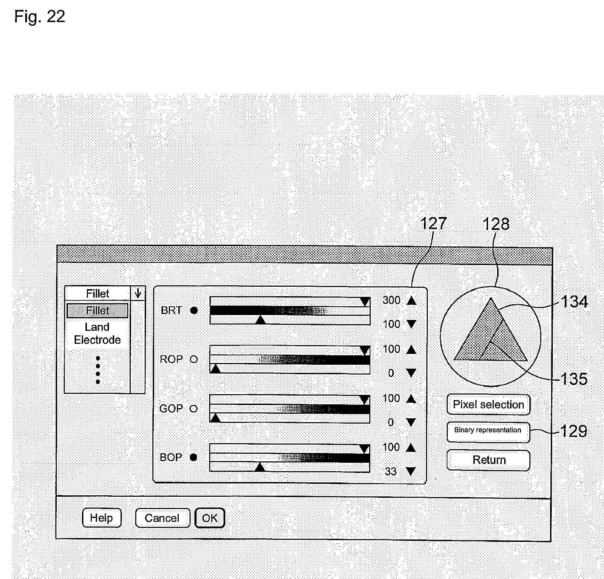

We, the inventors, have proposed a tool for assisting the setting of the color condition in the color highlight system as shown in Fig. 22 (See Citation 2). The tool permits the upper and lower limits of each of color feature values (the hue levels ROP, GOP, and BOP of red, green, and blue and the brightness BRT) to be determined and assigned to the color condition. The entry screen shown in Fig. 22 includes a setting window 127 for entering the setting levels of the color condition and a setting range display 128 for displaying the range of color to be extracted based on the set color condition. The setting range display 128 shows a hue zone 134 indicating all colors at a given level of the brightness. When the upper and lower limits of each color feature value are controllably determined by an operator, their defining area 135 to surround the color to be extracted based on the set color condition will appear in the hue zone 134. When a binary representation button 129 is pressed down, the area determined by the color condition is shown in a binary form. The tool hence allows the operator to, while monitoring the defining area 135 and the binary form, continuously modify the color condition until the appropriate extraction result is given.

Each known PC board inspecting apparatus has an advantage that the surface mount condition of a PC board is inspected simultaneously over different checkup items at higher speed and accuracy. However, in the actual action of the conventional PC board inspecting apparatus, the teaching of the inspection logic has to be done at each inspection item (each type of component that is the object to be examined and each type of error) and the judgment accuracy has to be increased to the level where there are no miss-judgment for not good boards, and where over-detection of judging good boards as not good boards is suppressed to such a (predetermined) acceptable level.

Describing further regarding the miss-judgment and the over-detection, no defectives must be passed on any account in any inspection. In case that the action of judgment is extremely difficult for discriminating between goods and not goods, it prefers to judge good boards as not good boards. As the over-detection is allowed, the number of not good boards will be higher thus increasing the overall cost or the cost of discarding. Otherwise, a repeat of the inspecting action will be needed hence offsetting the merit of automation of the inspecting action.

Each conventional PC board inspecting apparatus of the color highlight system finds difficult to carry out the teaching until both the miss-judgment and the over-detection are controlled to a negligible level while being advantageous for practicing the action of high-level inspection. Even using the above mentioned color condition setting assisting tool, the setting of the color condition will significantly depend on the skill and experience of an operator and become rarely free from setting error. Also, the setting will insist on the operator, skilled or not, repeating trial and error steps, hence declining the efficiency and wastefully consuming the labor and time for adjustment.

In addition, the inspection logic for the color highlight system of the PC board inspecting apparatus may contain an "area condition" as well as the color condition and the judgment condition. The area condition is used when a desired area to be inspected (particularly in the distribution of color) is extracted from the original image of interest. As the shape of the soldering is varied depending on various factors including the type of a board and the condition of soldering paste, its fault maybe found in different locations. In the color highlight system of the PC board inspecting apparatus, the inspection accuracy can be improved with the area to be inspected allocated to a region where a difference between good and not good is detected at the best. However, the setting of the area condition will also insist on the operator repeating trial and error steps with his or her skill and experience. Also, when the area condition is modified, the above-mentioned color condition and the judgment condition have to be readjusted thus disadvantageously increasing the number of steps in the teaching.

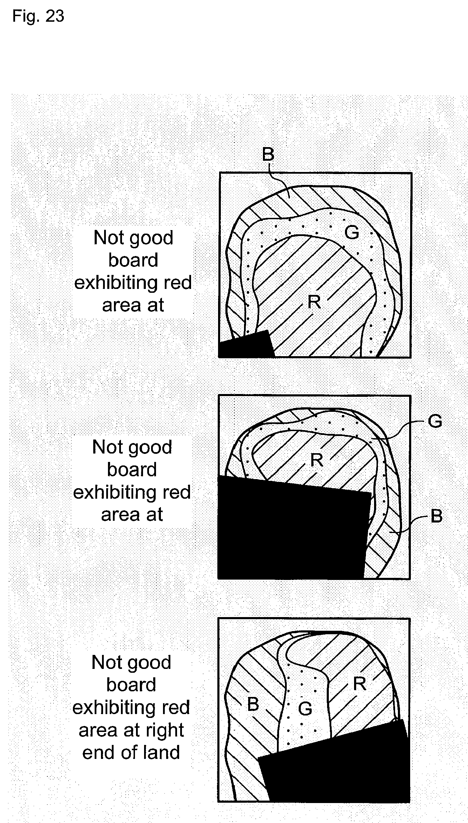

Moreover, even if the components are identical in the type and the error, their faults may be found in different locations and degrees. For example, Fig. 23 shows different "wetting errors (floating errors)" on identical components. As understood, red color areas pertinent to the wetting error are exhibited on the center, the distal end, and the right end of lands. This will prevent the operator from accurately identifying the error. Even with using any conventional assisting tool and repeating troublesome trial and error steps, the optimum setting of the area condition has not been an easy task.

Since the life cycle of products has been shortened in rapidly progressing manufacturing environment, a demand for minimizing and automating the action of teaching becomes intensified.

DISCLOSURE OF THE INVENTION

The present invention has been developed in view of the above aspect and its object is to provide a technology for automatically producing a desired form of the inspection logic from the area condition, the color condition, and the judgment condition or logic parameters to be used in the action of inspecting PC boards of a PC board inspecting apparatus.

The technology of the present invention allows a data processing apparatus (an inspection logic setting apparatus) to obtain a plurality of first images of component to be detected by the inspection and a plurality of second images of components to be rejected by the inspection. When the inspection incorporates the action of detecting a good PC board, the first images are produced of the good PC board on which relevant components are neatly surface mounted and the second images are produced of a not good PC board on which relevant components are erroneously surface mounted. In reverse, when the inspection incorporates the action of detecting a not good PC board, the first images are produced of the not good PC board and the second images are produced of a good PC board.

Then, the data processing apparatus divides each of the plurality of first and second images thus obtained into the blocks. The color distance between the plurality of first images and the plurality of second images is calculated in each block.

The color distance is a numerical representation of the difference in color (or color distribution) between all the pixels in the first image and all the pixels in the second image in one block. For example, the color distance may be calculated as a Euclid distance or a Mahalanobis distance in a color space. As the color distance in each block has been calculated, you can tell which block is greater in the difference in color between the first image and the second image. The color space is not limited to the above defined by the hue level and the brightness but may be any space of RGB, HSV, HSL, CMY, or YCC.

Next, the data processing apparatus selects one or more blocks from the plurality of blocks which are relatively greater in the color distance and assigns them to the area condition. Use of the area condition permits an area which is prominent in the difference of color between the first image and the second image to be selected as the inspection area. Therefore, appropriate inspection area can be automatically selected even when not good boards are varied in the appearance, thereby improving the judgment accuracy of the board inspection.

With reference to the area condition which has been determined, the data processing apparatus conducts an action of calculating the color condition and the judgment condition. More specifically, the data processing apparatus extracts as the object image an area determined by the area condition from the first image and as the reject image an area determined by the area condition from the second image, and then calculates the frequency distribution of measurements of each of one or more color feature values at each of the plurality of object points and the reject points where each pixel in the object image represents the object point while each pixel in the reject image represents the reject point. This is followed by calculating based on the frequency distribution of the measurements of one or more color feature values a range of the measurements of the color feature values where the separation between the measurement of the color feature values at the obj ect point and the measurement of the color feature values at the reject point is maximum. The type and the range of the measurements of one or more color feature values are then assigned to the color condition (The type and the range of the measurements of color feature values referred to as a color range hereinafter).

The above-described color feature values which constitute a color space may be used for searching the color range. In addition to the color feature values consisting of single color space, it is possible to select the plurality of the color feature value from different color spaces. It is preferable to include same color feature values as that with color space used for calculating the color distance.

The type of the color characteristic may be predetermined. For example, when one color which tends to be abundant in the object image but scarce in the reject image is known, its feature value(s) (color intensity and brightness) may be employed as the color feature values to be used as the color condition. This will interrupt declination in the inspection accuracy and minimize the throughput.

Preferably, the color feature value (s) to be used as the color condition may dynamically be determined. For example, the data processing apparatus has plurality of candidates for the color feature values consisting of the one or more color feature values. The data processing apparatus may be arranged to calculate for each of the plurality of candidates for the color feature values a range of the measurements of and the degree of separation between the measurement of color feature values where the separation between the measurement of color feature values at the object point and the measurement of color feature values at the reject point is maximum, to select the candidates for the color feature values which are then employed for determining the color condition through comparing the degree of separation, and to assign the type and range of measurements of one or more color feature values constituting the selected candidates of the color feature values to the color condition. The number of the candidates for the color feature values to be employed may be one or more. This allows the color condition (color feature values) which prominently shows the difference between the object image and the reject image to be automatically determined, thus contributing to the improvement of the inspection accuracy.

Next, the data processing apparatus extracts from each of the object images and the reject images pixel areas which satisfy the color condition and calculates a frequency distribution of the measurements of the one or more feature values in each of the plurality of pixel areas. It also calculates based on the frequency distribution of the measurements of the one or more feature values a range of the measurements of the feature values where the separation between the measurements of the feature values in the pixel areas extracted from the obj ect images and the measurements of the feature values in the pixel areas extracted from the reject images is maximum. The range and type of the measurements of the one or more feature values are assigned to the judgment condition.

The various feature values such as the surface measure, the area ratio, the length, the maximum width, the gravity center, the shape, and the other of the pixel area may be envisioned. One or more feature values may selectively be used depending on the type of a PC board to be inspected. It is also possible that the selection of the one or more feature values is configured to be automated, similar to the case of color feature value, or configured to be predetermined when the type of feature values often separated in the inspection have been known.

By the foregoing steps, the area condition, the color condition, and the judgment condition for determining the inspection logic are automatically produced. Since the area condition and the color condition are determined so that the difference between good boards and not good boards is prominent, the accuracy of the inspection can be improved.

It is desirable for the data processing apparatus determining the inspection logic to produce the area conditions of the different areas from the selectedblocks and then calculate the color condition and the judgment condition in relation to each of the plurality of area conditions. As two or more inspection areas but not a single inspection area on the PC board to be inspected are examined and their results are subjected to the final comprehensive judgment, the inspection accuracy can further be improved.

Although one area condition is divided into plural area conditions to be used, preferable is the data processing apparatus selecting a plurality of the blocks which are relatively greater in the color distance and grouping the selected plurality of blocks on the color distance to determine the plurality of different area conditions different area are produced. As the inspection areas are determined from groups of the blocks which are similar in the color distance, their variations will be minimized in the color distribution thus improving the reliability of the judgment. Also, since the number of the inspection areas is decreased by the blocks grouped on the length of the color distance, the action of setting the inspection logic and conducting the inspection can significantly be reduced in the processing load.

It is also preferable not only to make the number of the area conditions plural, but also make number of the color conditions and the judgment conditions corresponding to each of the area conditions plural. More specifically, the data processing apparatus calculates and determines the plural color conditions and the plural judgment conditions that are different from each other in relation to one area condition, or each of the plurality of area conditions. There are finally provided a plurality of combinations of the area condition, the color condition, and the judgment condition. As the results of the judgment on the individual combinations are produced and subjected to their final comprehensive judgment, the accuracy of the inspection can further be improved.

The final comprehensive judgment from the results of the judgment on the plural combinations of the area condition, the color condition, and the judgment condition may be conducted by various manners. For example, when a plurality of the inspection areas determined by the different area conditions have been extracted from the image of interest by the PC board inspecting apparatus, areas which satisfy the corresponding color condition are extracted and subjected to the action of judging whether or not the inspection areas extracted satisfy the judgment condition. Then, the individual results of the judgment from the plural inspection areas are subjected to logic calculation for determining the final judgment regarding the surface mounted state of the component. The logic calculation may involve logic sum, logic product, or their combination.

When the location of soldering error on the board is significantly varied, the logic calculation may employ a formula that judges status as not good only when any of the inspection areas contains a soldering error. When the location of good soldering on the board is significantly varied, the logic calculation may employ a formula that judges status as good only when any of the inspection areas is judged as good. When both the good and the not good on the board are varied in the location, the logic calculation may preferably employ a combination formula of logic sum and logic product. The formula of the logic calculation is determined by the data processing apparatus based on the degree of variation in the image of interest.

The foregoing steps are carried out by a program in the data processing apparatus. The inspection logic automatically produced (including the area condition, the color condition, and the judgment condition) is saved in the storage of the PC board inspecting apparatus for use in the inspecting action.

The PC board inspecting apparatus is arranged to project different colors of light at different incident angles onto a surface mounted component on a PC board, extract an inspection area determined by the area condition from an image which has been produced from the reflection of color light, pick up from the inspection area an area which satisfies the color condition, and judge the surface mounted state of the component by examining whether or not picked up area satisfies the judgment condition.

With the inspection logic consisting of different combinations of the area condition, the color condition, and the judgment condition and a set of logic formulas having been saved in the storage of the PC board inspecting apparatus, the action of inspecting a PC board is conducted by the following procedure. The PC board inspecting apparatus includes projects different colors of light at different incident angles onto a surface mounted component on a PC board, extracts inspection areas determined by their respective area conditions from an image which has been produced from the reflection of color light, picks up from each of the inspection areas an area which satisfies the corresponding color condition, judges whether or not the picked up area in the inspection area satisfies the corresponding judgment condition, and determines the final judgment on the surface mounted state of the component by assigning the results of the respective judgments to the relevant logic formulas.

The present invention is also intended to reside in an inspection logic setting method of a PC board inspecting apparatus including at least a part of steps of the procedure, a program for realizing the method, or a storage medium in which the program is saved. The present invention is further intended to reside in an inspection logic setting apparatus in a PC board inspecting apparatus including at least a part of device for conducting the procedure or a PC board inspecting apparatus having such apparatus. The device and procedure may be provided in different possible combinations for embodying the present invention.

According to the present invention, the inspection logic to be used by a PC board inspecting apparatus conducing the action of inspecting a PC board can be automatically produced thus minimizing and automating the steps of the teaching.

BRIEF DESCRIPTION OF THE DRAWINGS

Fig. 1 shows a hardware arrangement of a PC board inspection system according to one embodiment of the present invention.
Fig. 2 shows primary functions of the PC board inspecting apparatus.
Fig. 3 shows the relationship between solder fillet and image pattern.
Fig. 4 shows a flowchart showing a procedure of the PC board inspecting action.
Fig. 5 shows an example of binary forms of the inspection areas in a good board image and a not good board image.
Fig. 6 shows primary functions of the inspection logic setting apparatus of the first embodiment.
Fig. 7 shows a flowchart showing a procedure of setting the inspection logic of the first embodiment.
Fig. 8 shows an example of a good board image and a not good board image.
Fig. 9 shows the action of extracting a soldering area.
Fig. 10 shows the action of calculating the color distance and the action of determining the inspection area.
Fig. 11 shows an example of a two-dimensional color histogram.
Fig. 12 shows the action of searching a color range.
Fig. 13 shows the action of calculating a threshold from the surface measure histograms of a good board and a not good board.
Fig. 14 shows a problem caused by variations in the good board.
Fig. 15 shows a flowchart showing a procedure of setting the inspection logic of the second embodiment.
Fig. 16 shows a flowchart showing a procedure of producing the area condition by clustering.
Fig. 17 shows an action of inspecting a PC board of the second embodiment.
Fig. 18 shows an action of inspecting a PC board of the third embodiment.
Fig. 19 shows an action of inspecting a PC board of the fourth embodiment.
Fig. 20 shows an arrangement of a PC board inspecting apparatus of color highlight system.
Fig. 21 shows an example of color patterns in the image of interest.
Fig. 22 shows an assisting tool for setting of color parameters.
Fig. 23 shows examples of wetting error produced on same type of component.

DESCRIPTION OF THE PREFERRED EMBODIMENTS

Some preferred embodiments of the present invention will be described in more detail referring to the relevant drawings.

(First Embodiment)

(Arrangement of board inspection system)

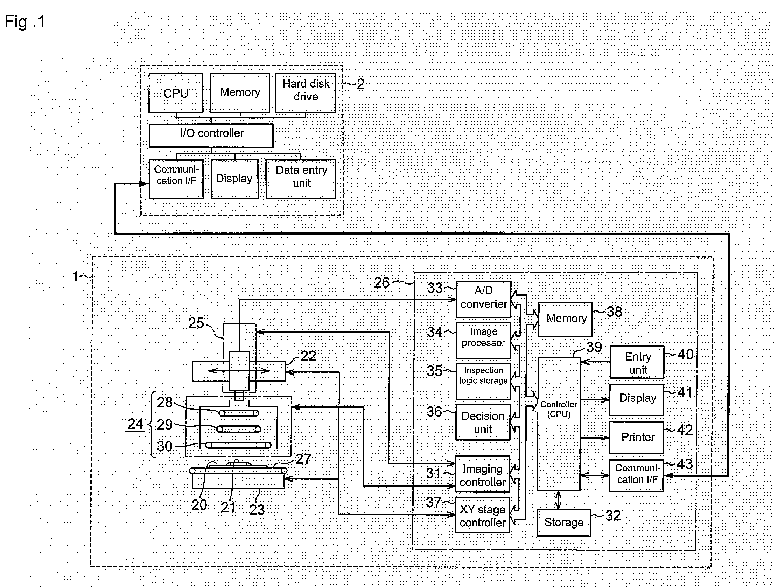

Fig. 1 shows a hardware arrangement of a PC board inspection system according to one embodiment of the present invention.
The PC board inspection system comprises a PC board inspecting apparatus 1 for conducting the action of inspecting boards and an inspection logic setting apparatus 2 for automatically generating an inspection logic to be used in the board inspection. Both the PC board inspecting apparatus 1 and the inspection logic setting apparatus 2 are connected for exchanging electronic data, such as images and parameters, over wired or wireless networks and/or recording mediums including MO disks and DVD disks. Although the PC board inspecting apparatus 1 and the inspection logic setting apparatus 2 are separately provided in this embodiment, they may be combined to a single unit where a main module of the PC board inspecting apparatus is equipped with a built-in form of the inspection logic setting apparatus.

(Arrangement of PC board inspecting apparatus)

The PC board inspecting apparatus 1 is designed for generating a color image from the reflection of color lights from a board of interest and automatically inspecting the quality of surface mounted components 21 (the state of their soldering) on the board 20 from the color image. The PC board inspecting apparatus 1 comprises substantially an X stage 22, a Y stage 23, a light emitter 24, an imaging device 25, and a control processor 26.
The X stage 22 and the Y stage 23 are equipped with electric motors (not shown) respectively which are driven by control signals from the control processor 26. In action, the X stage 22 actuates its motor for moving the light emitter 24 and the imaging device 25 along the x direction while the Y stage 23 actuates its motor for moving along the y direction a conveyor 27 on which the board 20 is supported.

The light emitter 24 consists mainly of three annular light sources 28, 29, and 30 which are arranged in circles of different diameters and operated in response to control signals from the control processor 26 for emitting three, red, green, and blue, colors of light at once. The light sources 28, 29, and 30 are positioned coaxially about the center of inspecting location so that their angles of elevation at the center of observation location are different. As the light emitter 24 is positioned in the foregoing location, its emitted light of colors (three, R, G, and B, colors in this embodiment) fall at different incident angles to the surface mounted component 21 on the board 20.

The imaging device 25 is a color camera positioned just above observation location to face downwardly. In action, the imaging device 25 when receiving the reflection of lights from the surface of the board 20 converts the reflection of lights into three, R, G, and B, color signals which are then received by the control processor 26.

The control processor 26 comprises an A/D converter 33, an image processor 34, an inspection logic storage 35, a decision unit 36, an imaging controller 31, an XY stage controller 37, a memory 38, a controller (CPU) 39, another storage 32, an entry device 40, a display 41, a printer 42, and a communication I/F 43.

The A/D converter 33 is a circuit for converting the R, G, and B color signals from the imaging device 25 into digital signals. The digital quantity of gradation data in each hue is transferred to the image data storage area of the memory 38.

The imaging controller 31 is a circuit equipped with interfaces and the like for connecting with the controller 39, the light emitter 24, and the imaging device 25. Upon receiving an output of the controller 39, the imaging controller 31, for example, adjusts the intensity of lights from the light sources 28, 29, and 30 in the light emitter 24 and makes a balance between the hue light outputs from the imaging device 25.

The XY stage controller 37 is a circuit equipped with interfaces and the like for connecting with the controller 39, the X stage 22, and the Y stage 23. Upon receiving an output of the controller 39, the XY stage controller 37 controls the action of both the X stage 22 and the Y stage 23.

The inspection logic storage 35 is provided for storing the inspection logic to be used in the board inspection. The PC board inspecting apparatus 1 is designed for conducting two or more kinds of inspecting actions including the fillet inspection for examining the shape of soldering and the component inspection for examining the presence of components. The inspection logic is thus prepared for each inspecting action, including an area condition for determining the area to be inspected (the inspection area), a color condition for determining a color pattern from the image in the inspection area (the pixel area), and a judgment condition for determining the judgment of the color pattern. More particularly, the area condition determines the location, the size, and the boundary of the inspecting area in an image to be examined. For example, "±10 pixels from the distal end of a lead in a direction perpendicular to the lead and 20 pixels along the direction of the lead". The color condition determines the feature values of color of interest (the brightness and the intensity of a blue color signal in this embodiment) and their range. For example, "the brightness of the pixels ranging from 150 to 250 and the intensity of the blue color signal ranging from 150 to 180". The judgment condition determines the feature values of interest (the surface measurement in this embodiment) and its range (the threshold in this embodiment). For example, "the surface measurement being not smaller than 60 % of the inspection area".

The image processor 34 is a circuit for extracting the inspection area from an image of the component 21 on the board 20 using the area condition, extracting an area satisfying the color condition from the inspection area in the image (to be inspected), and calculating the feature to be used in the judgment condition from the extracted area. The decision unit 36 is a circuit for receiving the feature value from the image processor 34 and examining whether or not the feature value satisfies the judgment condition thus to judge the surface mounted state of the component.

The entry unit 40 may be a keyboard or a mouse for entering various data about the operation and the board 20. The data entered is then transferred to the controller 39. The communication I/F 43 is provided for exchanging data with the inspection logic setting apparatus 2 or another external apparatus.

The controller 39 (CPU) is a circuit for conducting the calculating and controlling actions. The storage 32 may be a hard disk drive or a memory in which the programs carried out by the controller 39, the CAD data of the board, the judgment result of the board inspecting action, and other information are stored.

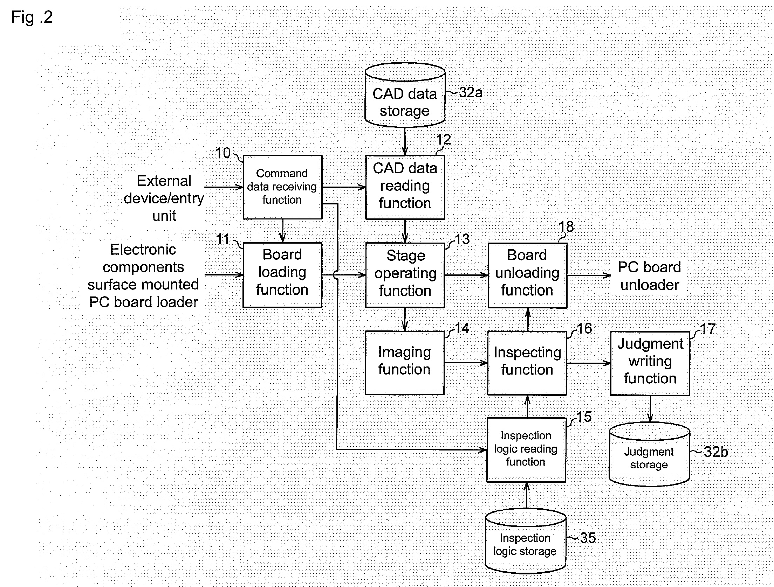

Fig. 2 shows primary functions of the PC board inspecting apparatus 1. The PC board inspecting apparatus 1 includes a command data receiving function 10, a board loading function 11, a CAD data reading function 12, a stage operating function 13, an imaging function 14, an inspection logic reading function 15, an inspecting function 16, a judgment writing function 17, and a board unloading function 18. The functions are carried out by the controller 39 operating the programs saved in the storage 32 to control the hardware devices. The storage 32 also includes a CAD data storage 32a and a judgment storage 32b for saving the CAD data and the result of the judgment respectively.

(Board inspecting action)

The board inspecting action of the PC board inspecting apparatus 1 will now be described. It is assumed that the board inspecting action examines a wetting error (floating error) . The wetting error is a type of mounting error in electronic component wherein the electrode of a surface mounted component is not properly joined to a fillet of solder.

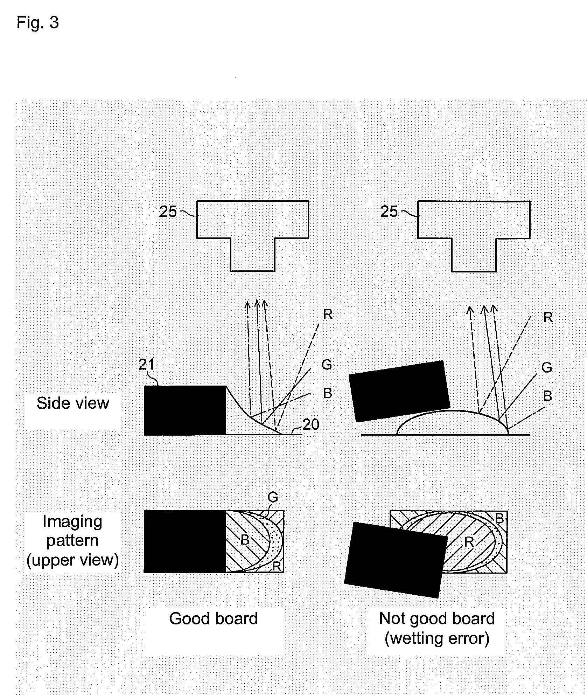

As shown at the upper half of Fig. 3, a good solder fillet has a moderate sloping shape, like the base of a mountain, sloping down from the component 21 to the land on the board 20. The wetting error results in a flat bump of solder on the land.

An image of the solder fillet is taken by the PC board inspecting apparatus 1 as illustrated at the lower half of Fig. 3. As red, green, and blue colors of the incident light fall at different angle to the solder fillet, their reflection intercepted by the imaging device 25 is varied in the hue depending on the tilting of the solder fillet. More particularly, a steep region of the slope is dominantly expressed by blue components of the reflection of the light which are lower in the incident angle while a region of little slope is dominantly expressed by red components of the reflection of the light. Accordingly, the larger blue hue range in the color pattern represents a good form of the solder fillet and the hue range of other color represents a not-good or fault form of the solder fillet.

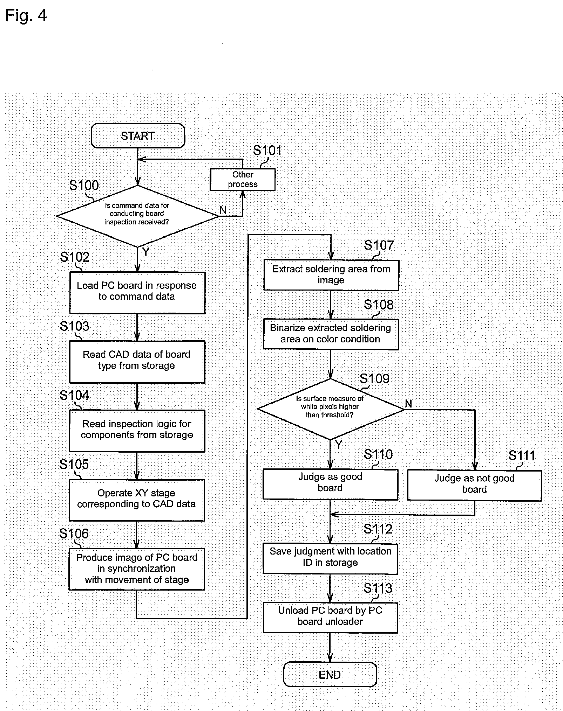

The wetting error inspection in this embodiment judges from the size (extension) of the blue range in the color pattern whether the solder fillet is good or not. A procedure of the wetting inspection will be explained in more detail referring to the flowchart of Fig. 4.

The command data receiving function 10 stands by before a command data for conducting the board inspecting action is received (no at Step S100, Step 101). When the command data is entered by operating the entry unit 40 or received via the communication I/F 43 from any external apparatus, it is transferred from the command data receiving function 10 to the board loading function 11, the CAD data reading function 12, and the inspection logic reading function 15 (yes at Step S100) . The command data contains the data about a board to be inspected (including the board type).

Upon receiving the command data, the board loading function 11 directs a PC board loader to load the board 20 to be inspected onto the conveyor 27 (Step S102) . The CAD data reading function 12 then reads the CAD data of the board 20 corresponding to the board type from the CAD data storage 32a of the storage 32 (Step S103). The CAD data contains the data about surface mounted components on the board 20 including the type, the number, and the location as well as the size and shape of the board 20.

The inspection logic reading function 15 reads from the inspection logic storage 35 the inspection logic to be used for examining the wetting of the components determined by the CAD data (Step S104). The inspection logic contains the area condition, the color condition, and the judgment condition.

This is followed by the stage operating function 13 operating the X stage 22 and the Y stage 23 through the XY stage controller 37 to obtain from the CAD data the data about the size, shape, and location of the components on the board 20 so that the plurality of components 21 mounted on the board 20 are located in sequence to the observation location (the location of imaging) (Step 5105).

The imaging function 14 then drives the imaging controller 31 to actuate the three light sources 28, 29, and 30 of the light emitter 24 for emitting the three, red, green, and blue, colors of light towards the board 20 simultaneously. Also, the imaging function 14 directs the imaging controller 31 to control the imaging device 25 for producing an image of each component 21 on the board 20 in synchronization with the movement of the two stages 22 and 23 (Step S106). The image of the component 21 is then saved in the memory 38.

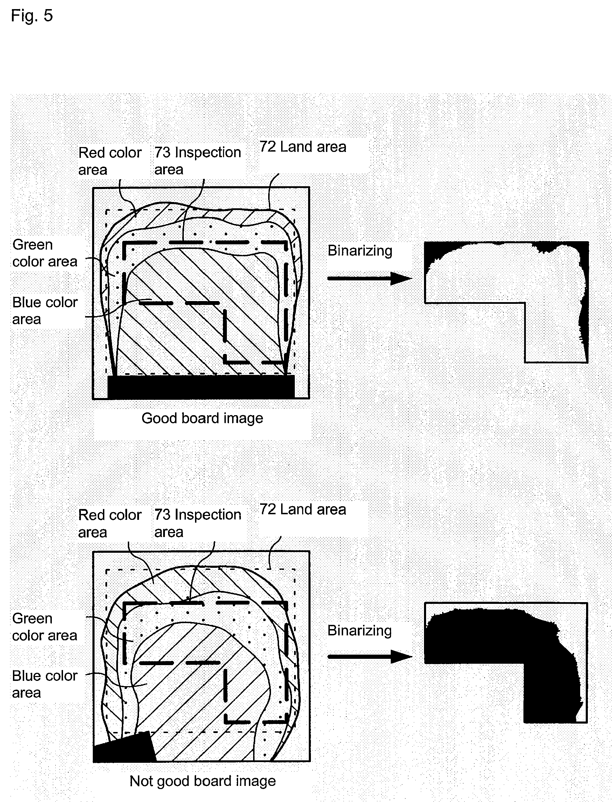

Then, the inspecting function 16 drives the image processor 34 to extract the soldering area from the image (Step S107) . The soldering area to be extracted is determined by the area condition of the inspection logic. The area condition may incorporate coordinates relative to the image area or coordinates relative to the land area or the component area in the image. In this embodiment, the area condition is defined by the coordinates relative the land area 72 as shown in Fig. 5. The inspection area 73 determined by the area condition is not limited to that shown in Fig.5 but may be of a circular shape, an oval shape, a polygonal shape, or any free-hand shape. The land area or component area in the image may automatically be specified using a template matching technique.

Then, the inspection function 16 converts the extracted soldering area (the area to be inspected) into a binary form using the color condition (Step S108). It is also noted that both the intensity of the blue color signal and the brightness are expressed by binary values at 256 levels ranging from 0 to 255. The color condition in this embodiment incorporates four values, that is, two, upper and lower, limits of the blue color signal and two, upper and lower, limits of the brightness. In the binarization, pixels included within the color range defined by the color condition are shifted into white pixels while the other pixels are shifted into black pixels.

The soldering area is illustrated in a binary form at the right half of Fig. 5. It is apparent that the blue area in the soldering area is expressed by the white pixels after the binarization, explicitly indicating a different (a feature) between the good area and the not-good area in the image. Also as clearly illustrated in Fig. 5, the inspection area 73 is much emphasized than the land area 72 in the difference between the good board image and the not-good board image.

Then, the inspecting function 16 directs the image processor 34 to extract the feature value of the white pixel area. The feature value is the surface measurement (the number of pixels) of the white pixel area. The inspection function 16 further directs the decision unit 36 to compare between the surface measurement of the white pixel area and its threshold (Step S109). When the surface measurement is higher than the threshold (yes at Step S109), the procedure goes to Step S110 for judging that the quality of soldering on the component 21 is good. When the surface measurement is not higher than the threshold (no at Step S109), the procedure goes to Step S111 for judging that the quality of soldering on the component 21 is not good.

This is followed by the judgment writing function 17 writing the result of the inspection together with its location ID (for identifying the component) into the judgment storage 32b (Step S112).

When all the components on the board 20 have been inspected, the board unloading function 18 directs a PC board unloader to unload the board 20 and the procedure is ended (Step S113).

The above-described board inspecting action allows the solder fillet to be captured in a three-dimensional form by examining the color pattern in a two-dimensional image, hence judging precisely whether the quality of soldering in the surface-mount technology is good or not. It also allows an area in the image to be extracted and analyzed (as the inspection area) where the difference between the good board and the not-good board in the image is explicitly apparent, thus ensuring a highly accurate result of the judgment.

Meanwhile, it is necessary for improving the accuracy of the judgment with no mis-judgment for not-good board and a minimum over-detection not higher than the acceptable level to determine optimum settings of the color condition and the judgment condition of the inspection logic corresponding to the object to be inspected. The shape of soldering may be varied depending on the type of the board, the material of soldering paste, and so on. Also, the not-good soldering may appear at different locations even if the components are identical and the type of soldering fault is the same. It is hence essential to determine the area to be inspected where the difference between the good board and the not-good board in the image is significant. The generation of the inspection logic (teaching) in this embodiment is automatically carried out by the inspection logic setting apparatus 2. This action will then be explained below in more detail.

(Arrangement of inspection logic setting apparatus)

The inspection logic setting apparatus 2 is implemented byacommoncomputer (dataprocessingapparatus) whichcomprises, as shown in Fig. 1, a CPU, a memory, a hard disk drive, an I/O controller, a communication I/F, a display, and a data entry unit (keyboard and mouse) as the fundamental hardware components.

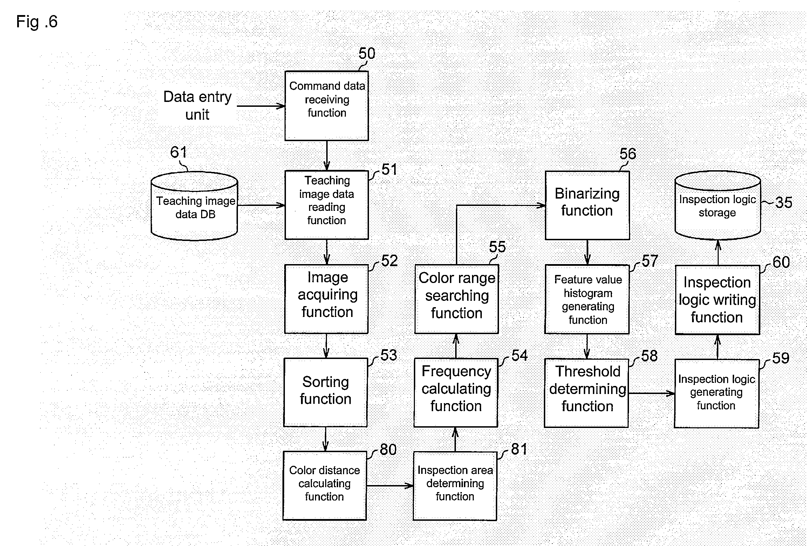

Fig. 6 shows the functions of the inspection logic setting apparatus 2. The inspection logic setting apparatus 2 includes a command data receiving function 50, a teaching image data reading function 51, an image acquiring function 52, a sorting function 53, a frequency calculating function 54, a color range searching function 55, a binarizing function 56, a feature value histogram generating function 57, a threshold calculating function 58, an inspection logic generating function 59, an inspection logic writing function 60, a color distance calculating function 80, and an inspection area determining function 81. The functions are carried out by the CPU reading and operating the programs saved in the hard disk drive or memory.

The hard disk drive includes a teaching image data DB 61 for storing the teaching image data to be used in the teaching action. The teaching image data incorporates the image of a component of interest produced by the PC board inspecting apparatus 1 and a teaching data which indicates whether the component in the image is to be detected (a good product) or to be rejected (a defective product with wetting error). It is desired for improving the accuracy of the teaching action to prepare tens to thousands of the teaching data for each of the good board and the not-good board.

(Setting of inspection logic)

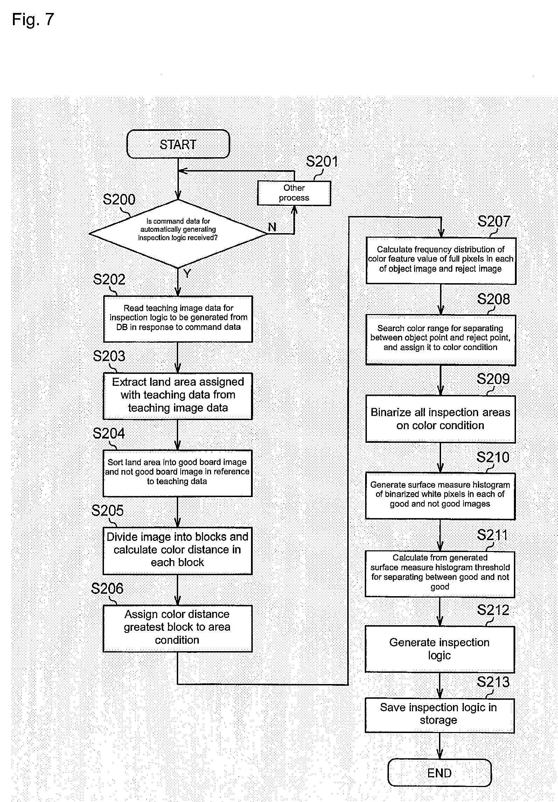

A procedure of setting the inspection logic will be explained referring to the flowchart of Fig. 7. This embodiment illustrates and example for producing the inspection logic that is intended for use in the above-described wetting error inspection.

The command data receiving function 50 stands by before a command data for conducting the automatic generation of the inspection logic (no at Step S200, Step S201) . When the command data is entered by operating the entry unit, it is transferred from the command data receiving function 50 to the teaching image data reading function 51 (yes at Step S200). The command data contains information specifying the teaching image data for which the inspection logic is generated, the type or board type of a board to be inspected, and the type of faults to be examined.

Upon receiving the command data, the teaching image data reading function 51 reads the teaching image data for an inspection logic to be generated from the teaching image data DB 61 (Step S202) . The teaching image data contains good board images (exhibiting the solder fillet where wetting error is generated) and not-good board images (exhibiting poor wetting forms of the solder fillet). The images are accompanied with teaching data.

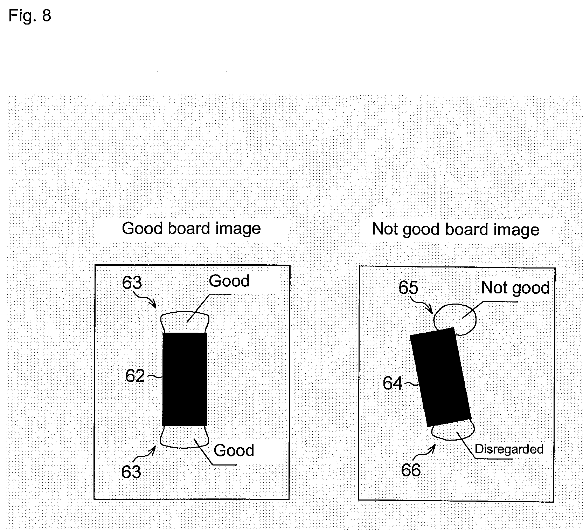

Fig. 8 shows examples of both good board image and not good board image. The good board image shows good solder fillets provided on the land areas 63, 63 at both sides of a component 62. The rand areas 63, 63 are specified with their teaching data "good". The not good board image however shows a component 64 mounted at its skew state with a land area 65 at one side having a wetting error. The land area 65 is thus specified with a teaching data "not good". A land area 66 at the other side is specified with a teaching data "disregarded".

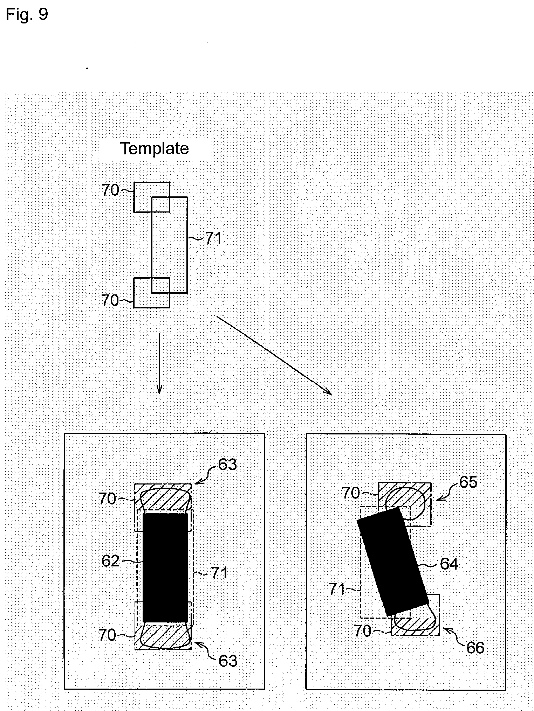

As the teaching image data have been read, the image acquiring function 52 extracts the land areas assigned with the teaching data from the teaching image data (Step S203). As shown in Fig. 9, the image acquiring function 52 has a template which comprises two land windows 70 and a component window 71. In action, the template is modified for enlargement and reduction in the size and its land windows 70 and component window 71 are shifted in their relative position so that they capture the corresponding land areas 63, 65, and 66 and components 62 and 64. The action of capturing the targets by the windows may be conducted by a template matching technique. As the result, the land areas 63, 65, and 66 in both the good and not-good images can be captured and specified. This allows the land areas to be extracted from the images when any overlap regions (denoted by the hatching in Fig. 9) with the component window 71 have been subtracted from the land windows 70. Alternatively, the land areas themselves (the entire area of the land windows 70) may be extracted.

Then, the sorting function 53 sorts the good board images (first images) and the not good board images (second images) from the extracted land areas with reference to the teaching data (Step S204) . More particularly, the land areas specified by the teaching data "good" are sorted as the good board images while the land areas specified by the teaching data "not good" are sorted as the not good board images. The land areas specified with the teaching data "disregarded" are omitted.

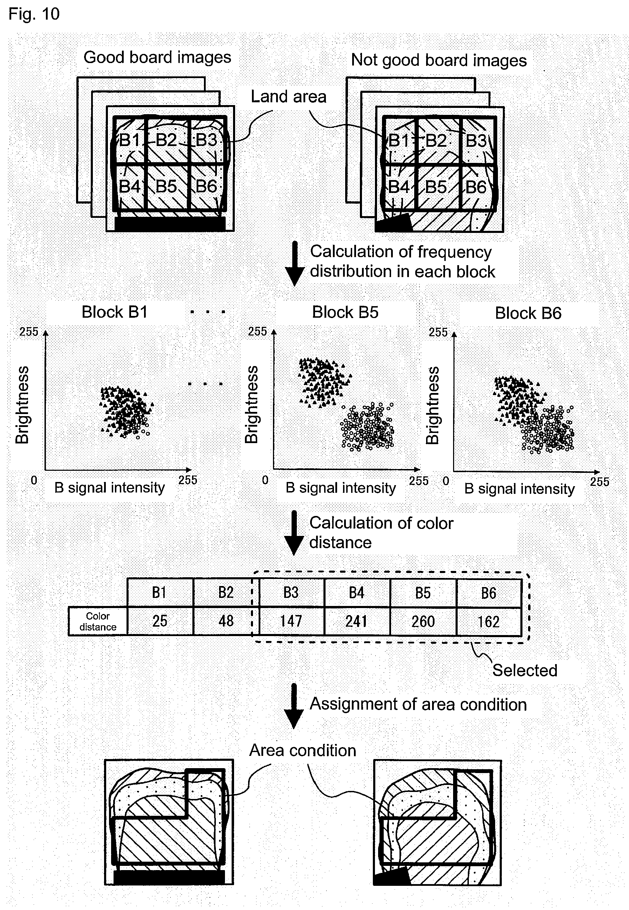

The color distance calculating function 80 divides each of the good and not good board images into the plurality of blocks, as shown in Fig. 10, and calculates the color distance in each block between the good board image and the not good board image (Step S205). Although the image is divided into six blocks B1 to B6 in Fig. 10, its division may not be restrictive in the number and the manner.

More specifically, the color distance calculating function 80 creates a frequency distribution of the color feature values of all the pixels in the block B1 of the good board image and a frequency distribution of the color feature values of all the pixels in the block B1 of the not good board image. The frequency distribution is determined so that the pixels in the good board image are distinguished from the pixels in the not good board image. The frequency distribution is also calculated for the other blocks B2 to B6.

The frequency distribution is visually expressed in the form of a color histogram. The color histogram presents the frequency (the number) of pixels at each point in the multi-dimensional space where the color feature value is expressed along the axis in a color space. The color histogram thus indicates the color distribution of the pixels in each block. It is noted that the pixel used here means the minimum resolution in the image. When the pixels are subjected at once to the mapping process, they may produce a mixture of colors. It is hence desirable to process each pixel.

In general, the color space is a multi-dimensional space including three or more color feature values. It is also desirable for producing a correct form of the color distribution of the pixel to calculate the frequency of at least two or more color feature values.

As described above, the development of color is frequently emphasized at the soldering area in this embodiment, blue at the good soldering or red at the not good soldering (because the soldering surface may create reflection that is close to mirror reflection). Also, the good soldering is expressed by the blue color of pixels while the not good soldering is expressed by the red color of pixels.

It is hence acceptable for determining the color condition or distinguishing between the good soldering in color and the not good soldering in color to examine the color feature value of one color (for example, blue) or two colors (for example, blue and red) with respect to hue. In this embodiment, the blue color is selectively used as being abundantly contained in the good board image but not in the not good board image and a combination of the brightness and intensity of the blue color are subjected to the frequency calculation.

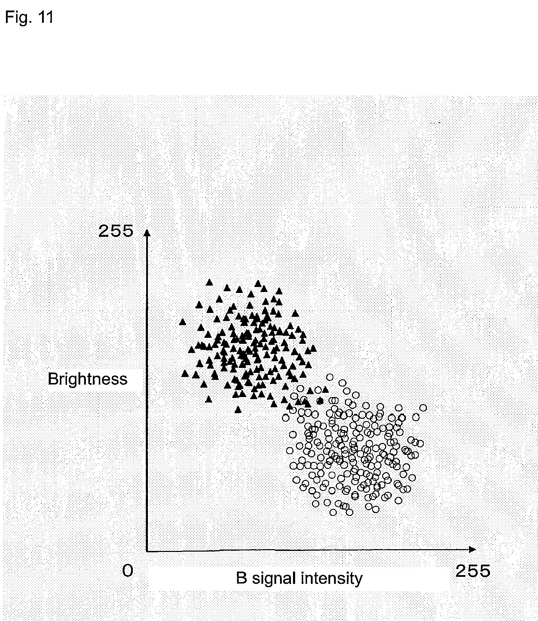

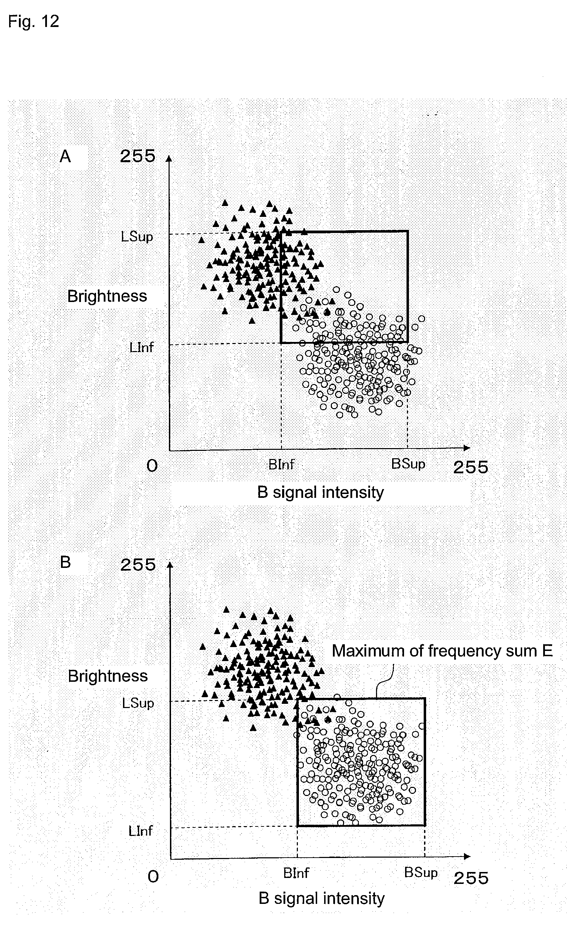

In Fig. 10, the color histogram is in two dimensions where the horizontal axis represents the intensity of the blue color and the vertical axis represents the brightness. Each axis exhibits 256 levels ranging from 0 to 255. The intensity of the blue color is declined towards zero where no blue component is contained in the pixel. The intensity of the blue color is increased as it comes closer to 255. The higher the level, the higher the brightness will be increased. The white dot (o) represents the point where the frequency of the pixel in the good board image is one or more. The black triangle (▲) represents the point where the frequency of the pixel in the not good board image is one or more. Both the white dot and the black triangle contain the frequency data (the number of pixels in the color) as well as the brightness and the blue color intensity. Figs. 11 and 12, described below, show the white dots and the black triangles equal to those of Fig. 10 which indicate not the pixels but the three-dimensional data (the blue intensity, the brightness, and the frequency).

The color distance calculating function 80 then calculates the color distance in the frequency distribution between the good board image and the not good board image. The color distance may be selected from (1) Euclid distance in the color distribution between the good and not good representative points (for example, the gravity points), (2) weighted distance in the color distribution between the good and not good weighted points (for example, the weighted brightness when the difference in the brightness is concerned), (3) Mahalanobis distance between the representative point (for example, the gravity point or the end point) in the not good image and the color distribution of the good image, and inversely , (4) Mahalanobis distance between the representative point (for example, the gravity point or the end point) in the good image and the color distribution of the not good image. Alternatively, the color distance may be calculated using any other applicable technique. Since the color distance in each block is calculated, it can tell which block is significant in the difference of color between the good image and the not good image.

When the color distance has been calculated, the inspection area determining function 81 selects one or more blocks out of the plurality of (six, in this embodiment) blocks where the color distance is relatively great and assigns the selected block(s) to the area condition to be used in the board inspection (Step S206). The selection of the block(s) may be based on the requirement that (1) the color distance is greater than its predetermined threshold, (2) the blocks where the color distance is greater are accumulated to a desired number, or (3) the color distance is higher than an average between the blocks. The selection of the block (s) is not intended to be so limited. In this embodiment, the blocks B3, B4, B5, and B6 are selected and the area where these blocks are put together is assigned to the area condition as shown in Fig. 10.

As the area condition has been decided, it is used for calculating the color condition. It is now assumed that a region in the good board image defined by the area condition is termed "object image" and a region in the not good image defined by the area condition is termed "reject image". The object image exhibits a color pattern from a good form of the solder fillet to be detected by the board inspection while the reject image exhibits a color pattern from a not good form of the solder fillet to be rejected. The color condition that is optimal for the wetting error inspection is equivalent to an optimum color range which contains more color pixels of the object image but less color pixels of the reject image.

The frequency calculating function 54 calculates a frequency distribution of the color feature value of all the pixels in each of the object image and the reject image (Step S207). The pixels in the object image are treated as "object points" while the pixels in the reject image are treated as "rej ect points" for ease of the distinguishing from each other during the calculation of the frequency distribution. The color histogram to be used here is identical to the two-dimensional histogram used in the color distance calculation, where one of the two axes represents the blue color intensity and the other represents the brightness. Fig. 11 shows a color histogram after the mapping, where the horizontal axis represents the intensity of the blue color and the vertical axis represents the brightness. Each is expressed in 256 levels ranging from 0 to 255. The intensity of the blue color is declined towards zero where no blue component is contained in the pixel. The intensity of the blue color is increased as it comes closer to 255. The higher the level, the higher the brightness will be increased. The white dot (o) represents the point where the frequency of the pixel (at the object point) in the good board image is one or more. The black triangle (▲) represents the point where the frequency of the pixel (at the reject point) in the not good board image is one or more.

Then, the color range searching function 55 determines from the object points and the reject points in the frequency distribution shown in Fig. 11 the color range for separating optimally between color distribution of the object points and that of the color distribution of the reject points (Step S208) . In this embodiment, the four values are employed for simplicity of the algorithm, that is, the lower limit (BInf) and the upper limit (BSup) of the intensity and the lower limit (LInf) and the upper limit (LSup) of the brightness, as shown in Fig. 12a. The optimum color range to be obtained is combination of the four values (BInf, BSup, LInf, and LSup) in which a more number of the object points (o) and a less number of the reject points (▲) is contained.

More particularly, the color range searching function 55 calculates a sum E of the frequencies in each color range while modifying the four values BInf, BSup, LInf, and LSup (Equation 1) and determines the color range when the sum E is at the maximum. The sum E of the frequencies indicates a difference between the number of the object points and the number of the reject points in the color range. Fig. 12b shows the color range when the sum E of the frequencies is at the maximum.

$$E = \sum_{b=BInf}^{BSup} \sum_{l=LInf}^{LSup} \{S(b,l) - R(b,l)\}$$

where b is the intensity of blue color, 1 is the brightness, S(b, 1) is the frequency of the object points at the point (b, 1), and R(b, 1) is the frequency of the reject points at the point (b, 1).

The color range searching function 55 assigns the color range where the frequency sum E is at the maximum to the color condition for the inspection. This embodiment allows a group of the color feature values to be automatically calculated for appropriately separating the image into the object image (the object points) and the reject image (the reject points) and assigned to the color condition.

In this embodiment, the four parameters including the upper and lower limits of the blue color intensity and the upper and lower limits of the brightness are employed to incorporate the color condition but not intended to be so limited. The parameters maybe any other color feature values selected from the intensity, brightness, color saturation, hue, CIEXYZ stimulates X, Y, and Z, chromaticity values x, y, and z, CIELAB values L*, a*, and b*, and CIELUV values L*, u (u'), and v (v') of each of blue, red, green, cyan, magenta, and yellow. Also, not only two but also one, or three or more of the color feature values may be used to incorporate the color condition. The color parameters to be employed for the color condition may be appropriately selected corresponding to the color pattern of a soldering area in the image produced. It is also preferable to prepare a set of the color feature value candidates of one or more different types for selective use to determine the color condition through carrying out the foregoing frequency distribution and color condition calculation of each candidate. More specifically, the degree of separation (corresponding to the sum E of the frequencies that is at the maximum in this embodiment) between the object point and the reject point in the frequency distribution of each color feature value candidate is calculated and compared with other degree of separation to determine favorable one of the color feature value candidates to be employed. For example, the color feature value candidates in which the degree of separation becomes the greatest, or their consecutive ones from the greatest degree of separation may be selected. The color range may be determined using any other known method than the described method such as a discrimination analyzing technique or an SVM (support vector machine) technique.

Then, the judgment condition for the inspection will be automatically determined from the color condition.

This action starts with the binarizing function 56 binarizing the inspection area in both the good board image and the not good board image with reference to the color condition (Step S209). The binarizing involves converting the pixels in the color range determined by the color condition into white pixels and the other pixels into black pixels.

As the area to be inspected has been binarized, the white pixels are dominant in the good board image while they are scarce in the not good board image (See Fig. 5). Using the binarized images, the feature value for discriminating between the good board and the not good board can quantitatively be calculated with ease. The feature value may be selected from the area, the area ratio, the gravity center, the length, and the shape of the white pixel area. It is now assumed that the area or surface measure is the feature value. Alternatively, two or more feature values may be used in a combination instead of one. Similar to the above described color feature values, the feature value may be predetermined in its type. A pair of the feature value and its threshold by which good board image and not good board image can be separated the best or their combination may dynamically be used as the judgment condition when the threshold has been calculated from the plurality of candidates of the feature value by the following manner.

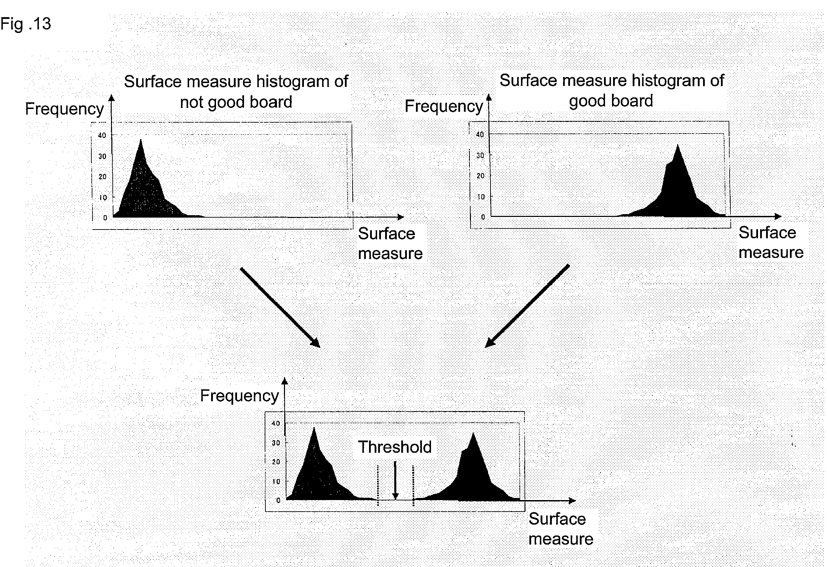

The feature value histogram generating function 57 calculates the frequency distribution of the area of the white pixels in each of the good board image and the not good board image in order to find a difference in the trends in the distribution of the feature values between the good board image and the not good board image (Step S210). In this embodiment, the frequency distribution of the area is expressed in an area histogram for visual presentation. Fig. 13 shows examples of the area histogram of the good board image and the not good board image (referred to as simply a good board histogram and a not good board histogram hereinafter). It is apparent that there is explicitly a difference in the feature value distribution between the good board image and the not good board image.

Then, the threshold calculating function 58 calculates the threshold value most preferable for discriminating between the feature value of the good board image and the feature value of the not good board image from the frequency distributions of the good board histogram and the not good board histogram (Step S211) . As a variety of optimally separating between two peaks in the histogram are proposed, any one of them may be used. For example, the Otsu' s method may be used. Alternatively, the threshold may be at the location spaced by 3σ from the end of the peak in the good board image. The threshold for discriminating between the good board and the not good board can be determined by any of the foregoing methods.

The inspection logic generating function 59 generates an inspection logic using the area condition, the color condition, and the judgment condition (Step S212). The inspection logic is hence that the board to be examined is good when, for example, the pixels in the area in the image defined by the area condition "20 pixels along the lead line, $\pm 10$ pixels extending from the distal end of the lead line in the direction orthogonal to the lead line" and the color condition "the brightness of the pixels ranging from 150 to 250 and the intensity of the blue color ranging from 150 to 180" satisfy the judgment condition "the area of the pixels is 60 % or more of the inspection area". When the condition is not satisfied, the wetting error is present. Finally, the inspection logic writing function 60 writes the inspection logic into the inspection logic storage 35 of the PC board inspecting apparatus 1 (Step S213) before the inspection logic setting is ended.

As set forth above, this embodiment allows the inspection logic for use in the board inspecting action to be automatically produced, thus significantly decreasing the time and load required for the teaching.

Also, as the optimal area condition, color condition, and judgment condition are determined favorably using the algorithm, they contribute to the higher precision of the judgment from a color image. The color condition and the judgment condition can be improved in the reliability as the teaching image data provided at the initial stage is abundant.

(Second Embodiment)

According to the first embodiment, the appropriate area condition is determined from the teaching image for precisely examining the wetting of solder. However, even if the board is judged as good, its soldering may be varied depending on its type as well as its components mounted thereon. It is inevitable that a color pattern similar to that of the not good soldering due to wetting error may appear partially in the inspection area on the good board.

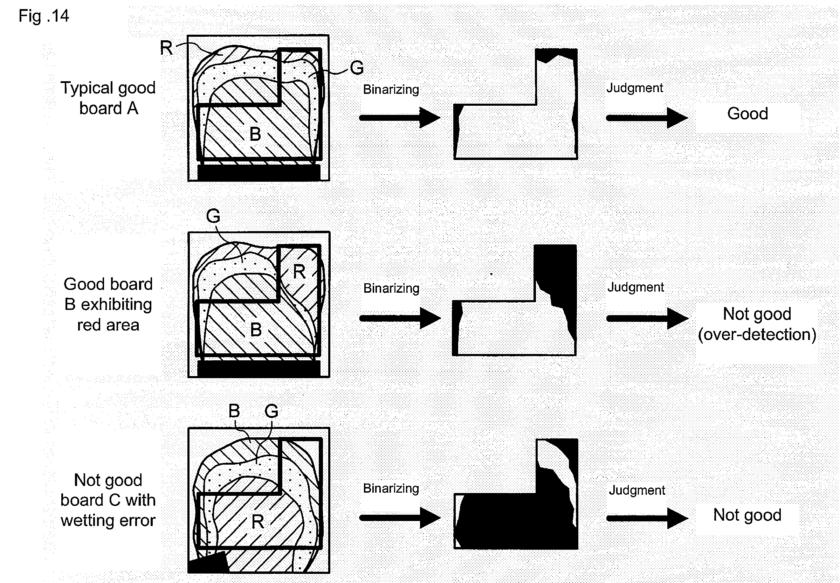

Fig. 14 shows an example. In Fig. 14, the good board exhibiting its typical color pattern is denoted by A, the not good board exhibiting its partial not good color pattern is denoted by B, and the not good board exhibiting its color pattern of wetting error is denoted by C. The image of the good board B, while displaying a large extension of the blue area indicating the good soldering, also displays a small extension of the red area at the right side portion of inspection area indicating not good soldering. It is understood that the pixel area is decreased after the binarizing action and thus judged as not good (over-detection). The more the over-detection, the more the number of good boards will be discarded as not good boards, thus increasing the production loss or requiring a repeat of the inspection. As the result, the merit of the automatic inspection will be declined.

For overcoming the above drawback, this embodiment permits the inspection area to be divided into smaller sub-inspection areas and each sub-inspection area to be assigned with the inspection logic. The board is inspected at each sub-inspection area but not the full single inspection area. Since the judgment is comprehensively given from their respective inspections over the small sub-inspection areas, its final accuracy will be improved while conquering variations in the good board judgment due to random partial wetting error in the inspection area shown in Fig. 14.

(Setting of parameters)

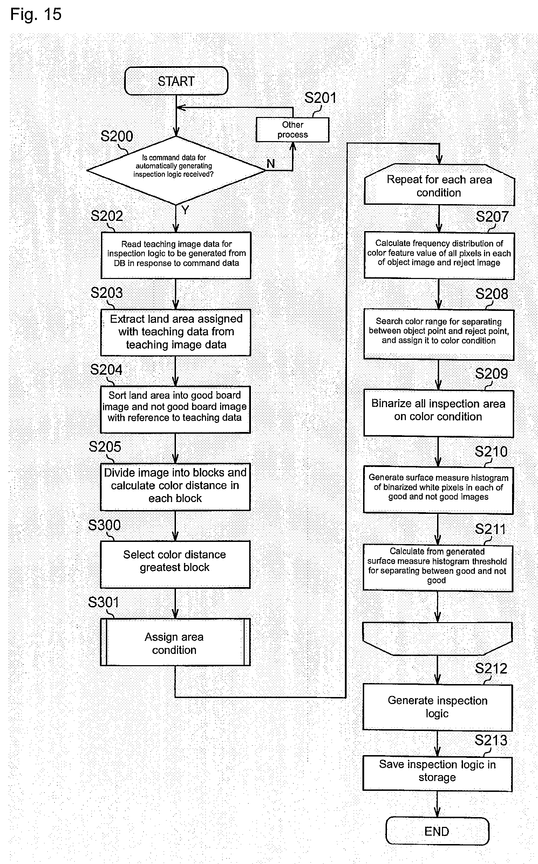

Referring to the flowchart of Fig. 15, a procedure for determining parameters in this embodiment will be described. The other steps than steps of determining a group of the area conditions for defining the sub-inspection areas are identical to those of the first embodiment (See Fig. 7) and will be explained in no more detail while like steps are denoted by like numerals.

The procedure starts with reading the teaching image data upon receiving a command data, extracting the land areas from the image data, and sorting the good board images from the not good board images (Steps S200 to S204). Then, similar to the first embodiment, each of the good and not good board images is divided into the plurality of blocks and the color distance is calculated in each block (S205). The blocks are selected where the color distance is relatively greater (step S300) . It is also assumed similar to the first embodiment that the blocks B3, B4, B5, and B6 are selected.

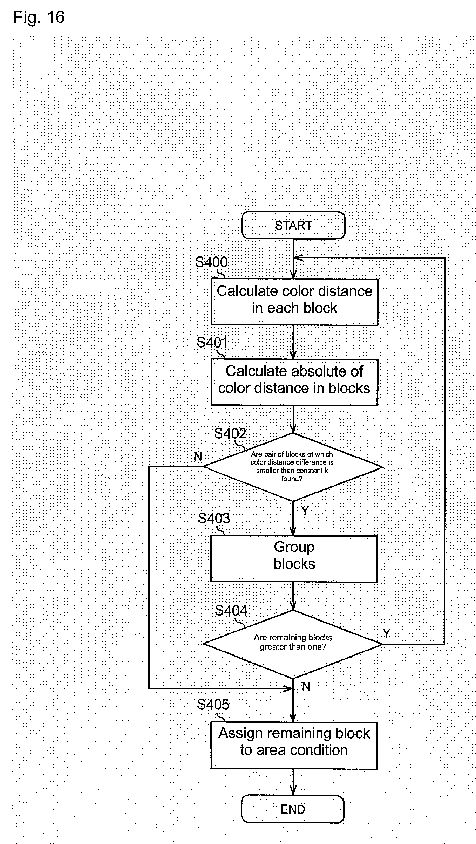

This is followed by the inspection area determining function 81 separating the blocks B3, B4, B5, and B6 into groups based on the length of the color distance and assigning each block group to the area condition (S301). In this embodiment, the separation of the blocks into groups is carried out using a clustering technique as shown in Fig. 16.

More particularly, the inspection area determining function 81 calculates the color distance in each block (Step S400). The calculation of the color distance is identical to that at Step S205. The color distance determined at Step S205 can be used at the initial cycle.

The inspection area determining function 81 then calculates the absolute of a difference in the color distance between the blocks (Step S401) . The absolute of the difference in the color distance is calculated at each pair of the blocks.

The inspection area determining function 81 examines whether or not the absolute of the difference in the color distance is greater than a reference level k (Step S402). Then, the blocks of which the absolute of the difference in the color distance is not greater than k are grouped (Step S403). When the number of the remaining blocks is greater than one (yes at Step S404), the steps from S400 are repeated for the remaining blocks.

When it is judged that there is no more group of blocks of which the absolute of the color distance difference is not greater than k (no at Step S402) or that the remaining blocks are reduced to one (no at Step S404), the repeat of the steps is ended and the inspection area determining function 81 assigns the remaining blocks to the area condition (Step S405). It is now assumed that the blocks B3 and B6 are grouped, the blocks B4 and B5 are grouped, and the two area conditions 1 and 2 are assigned. It is also noted that, in case that the area condition is one, variations in the good or not good board image are negligible and the division of the inspection area is not needed.

Since the inspection area contains two or more blocks which are similar in the color distance, its color distribution will be minimized in variation thus improving the reliability of the judgment in the board inspection. Also, while the blocks which are similar in the color distance are grouped, the number of the inspection areas can be minimized thus contributing to the reduction of the load during the inspection logic setting action and the board inspecting action.

As the area conditions have been determined, the color condition and the judgment condition are calculated with of the area conditions (Steps S207 to S211) and finally the inspection logic is generated (Steps S212 and S213).

(Board inspection)

The action of inspecting the board is then conducted by the same manner as of the first embodiment (See Fig. 4) to examine each small sub-inspection area. The results of the small sub-inspection areas thus obtained are then subjected to a logic calculation for finally determining the judgment for the surface mounted state of the component.

Since the case that good PC boards are variable in the color pattern in this embodiment, it is preferable that the logic calculation can disregard the "not good" judgment when it is determined as "not good" only in some of the sub-inspection areas. For example, when any one of its small sub-inspection areas is judged as "good", the surface mounted state of the board is judged as "good". Only when all the small sub-inspection areas are judged as "not good", surface mounted state of the board is judged as "not good".

Assuming that the judgment of "not good" is "true" and the judgment of "good" is "false", the logic calculation involves calculating a logic product of the individual judgments over the sub-inspection areas (i.e. when "true"="not good", the final judgment is also based on "true"="not good") . On the contrary, when the judgment of "good" is "true" and the judgment of "not good" is "false", the logic calculation involves calculating a logic sum of the individual judgments (when "true"="good", the final judgments is also based on "true"="good").

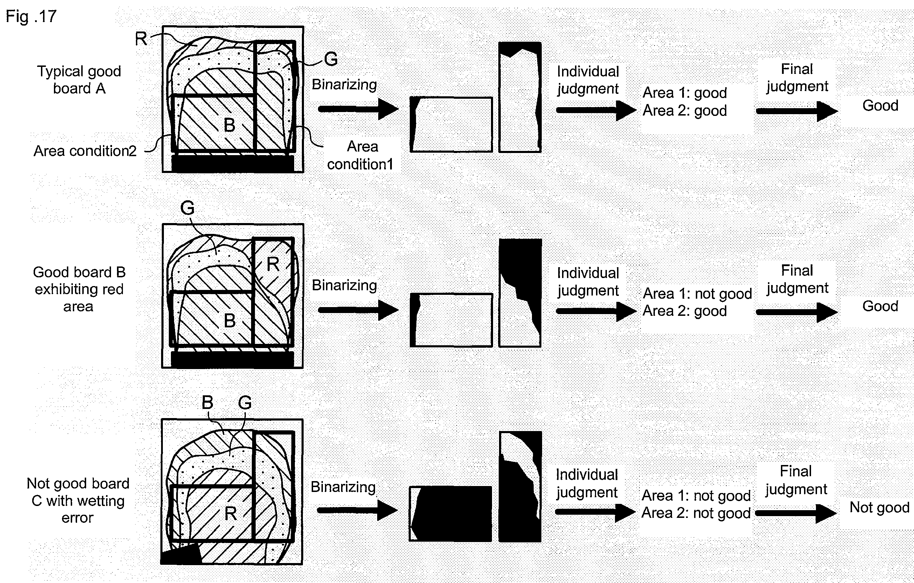

Fig. 17 shows the board inspecting action of this embodiment. As compared with the procedure shown in Fig. 14, this embodiment allows the good PC board B to be correctly judged even when exhibiting a color pattern in a part of the inspection area which is similar to that of a not good PC board.

(Third Embodiment)

The board inspecting action of the second embodiment is favorably applicable to a case that the good PC boards are variable in the color pattern. The third embodiment is applicable to a case that the not good PC boards are variable in the color pattern.

When soldered bumps of the not good board are not uniform from place to place, they may exhibit partially a color pattern similar to that of the good board. This will lead to miss judging not good board as good board in either the first or second embodiment. It is hence critical to avoid such miss judgment of the not good board.

In the case that not good PC board are variable in the color pattern a logic calculation in which "good" judgment may be disregarded when it is determined as "good" in only some of the sub-inspection area. For example, when any small sub-inspection area of its entire inspection area is judged as "not good", the surface mounted state of board is judged as "not good". However, surface mounted state of board the surface mounted state of board is judged as "good" only when all the small sub-inspection areas are judged as "good".

Assuming that the judgment of "not good" is "true" and the judgment of "good" is "false", the logic calculation involves calculating a logic sum of the individual judgments over the sub-inspection areas. On the contrary, when the judgment of "good" is "true" and the judgment of "not good" is "false", the logic calculation involves calculating a logic product of the individual judgments.

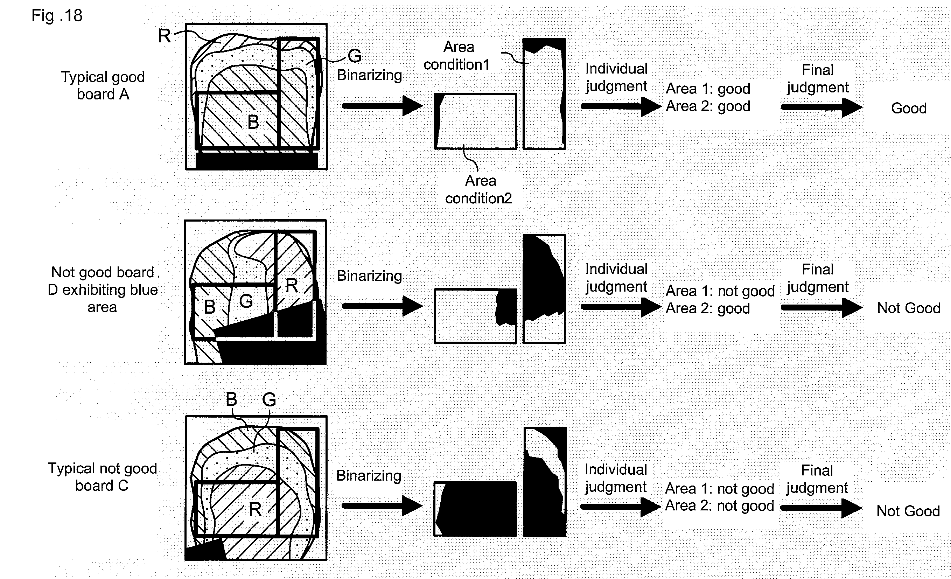

Fig. 18 shows results of the board inspecting action of this embodiment. It is apparent that the correct final judgment is also obtained for the not good board D exhibiting in a part of the inspection area a color pattern which is similar to that of the good board.

The action of generating the inspection logic can be conducted by the same manner as of the second embodiment. It is possible for finding the variability of the good board or not good board to examine a variance (or a standard deviation) in the color distribution of the good or not good board image mapped to the color histograms. Using a logic formula determining function of the inspection logic setting action, it is examined and determined which of the good board or the not good board is more variable in the color distribution of their image. The result is then used to automatically determine whether the logic product or the logic sum is calculated. Then, the logic formula is installed in the inspection logic.

(Fourth Embodiment)

The second and third embodiments allows the logic product or the logic sum to be calculated from the results of the individual judgments over the two small sub-inspection areas and used as the final j judgment. Both are favorably applicable to a component which is highly variable in the pattern of good results and not good results, respectively.

The fourth embodiment is designed for obtaining final judgment from the results of the judgment over three or more small sub-inspection areas by the use of logic formulas in which logic product and logic sum are combined. This will favorably be applicable to a component which is highly variable in both the pattern of good results and the pattern of not good results.

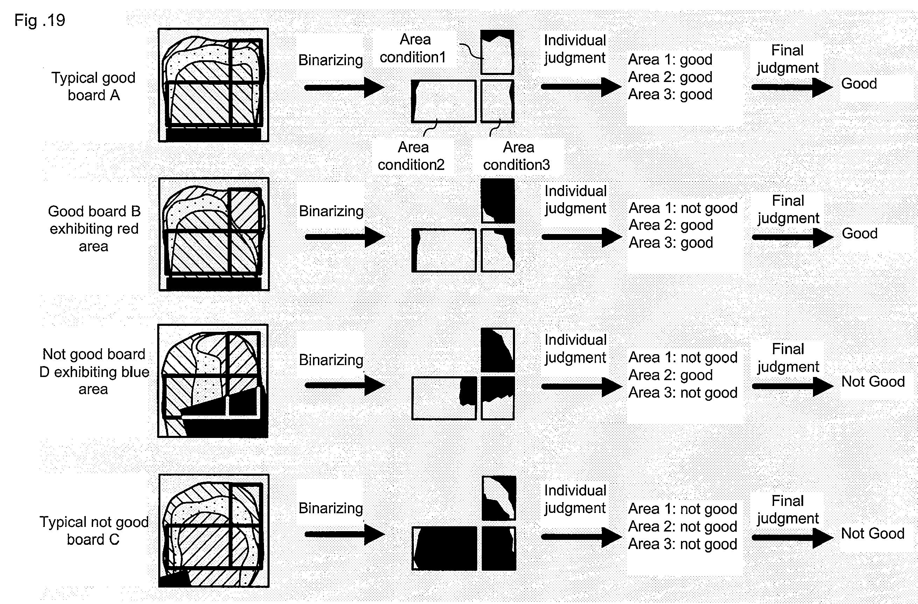

Fig. 19 shows exemplary results of the board inspection action of this embodiment. Assuming that the judgment of "not good" is "true" and the judgment of "good" is "false", the final judgment R is calculated from three results R1 to R3 over the three sub-inspection areas using the following logic formula.

$$R = (R1 \cup R2) \cap R3$$

where the symbol $\cup$ is the logic sum and the symbol $\cap$ is the logic product.

This method permits all the good board A exhibiting a typical good color pattern, the good board B exhibiting partially a color pattern similar to that of the not good board, the not good board C exhibiting a typical color pattern for wetting error, and the not good board D exhibiting partially a color pattern similar to that of the good board to be judged correctly.

The logic formula may be determined by the logic formula determining function in the inspection logic setting action where possible logic formulas are tried through calculating with a plurality of sample images (of good and not good PC boards) and one of them is selected as the optimum logic formula (which allows no miss judgment of a not good board as good board and minimizes the effect of over-detection judging the good board as a not good board).

(Modified Example)

The above described embodiments are illustrative but not intended to be so limited. Various modifications and changes may be made without departing from the technology of the present invention.

For example, while the area condition is produced from a group of the selected blocks in the embodiments, it may be modified through enlargement or reduction in the size as required to obtain the optimal area condition. More particularly, the area condition from the selected blocks is used as an initial area condition for determining the color condition and the judgment condition. Then, the degree separation between the good board histogram and the not good board histogram is calculated in the feature value histogram at that time. Then, as the area condition is being modified by a predetermined rule, the color condition and the judgment condition and the degree separation are calculated on each modified form of the area condition. Finally, the area condition in which the degree of separation is maximum, and the color condition and judgment conditions corresponding to the area condition are employed as the inspection logic. As the result, the inspection logic will be optimum thus contributing to the improvement of the inspection accuracy.

In the second to fourth embodiments, two or more of the area conditions are produced from grouping (clustering) the blocks used in the determination of the initial area condition. Alternatively, the determined single area condition itself is divided into small sub-inspection areas (for example, 100 sub-inspection areas) which are then grouped (by clustering) to have two or more area conditions. This will increase the freedom of the size and the shape of the sub-inspection area, thus improving the flexibility to variations.

The color condition in the embodiments is determined by the maximum and minimum of the two color feature values to define a four-sided shape area on the two-dimensional plane. The color range is not limited to the four-sided shape but may be a circular shape, a polygonal shape, or any free-hand shape on the two-dimensional plane. When three or more parameters are applied, their maximum and minimum may be obtained and used in any combination for determining the color range. Alternatively, they may be regarded as a color range expression about combination (s) of two or more parameter (for example, to define a spherical shape in a three dimensional space) . Moreover, the color range may be searched by any other known technique than that described in the embodiments, such as discrimination analysis or SVM (support vector machine).

Although its embodiments reside in the wetting error inspection, the present invention may be applied to any other action of inspecting PC boards where the inspection area is specified from an image of interest, extracted on a color condition, and subjected to judgment with any of the feature values of the extracted area over a judgment condition.

While the feature value for use in the judgment is a surface measure in the embodiments, it may be selected from area ratio, length, maximum width, and gravity center and the like. The area ratio is a ratio of the binarized area in the land window. For example, when a component is displaced from the land area and soldered, its soldering area is varied in the size and thus in the area ratio. when the area ratio is used as a feature value, its use for the inspection of component displacement can equally be effective. The length extends along the longitudinal direction or lateral direction of a white pixel area. The maximum width is the greatest of the length of the white pixel area. The gravity center is a relative position of the gravity center of the white pixel area to the land window.

The feature value may arbitrarily be chosen when appropriate for accurate judgment. Preferably, a combination of the feature values may be used for improving the judgment accuracy. It is also possible for determining the inspection logic to pick up two or more of the feature values and select the best among them for separating between the good board and the not good board. Although the judgment condition is determined from the surface measure histogram in the embodiments, it may employ any feature value histogram (such as area ratio histogram, length histogram, maximum width histogram, or gravity center histogram) corresponding to the different feature values. For example, when the area ratio histogram replaces the surface measure histogram, the ratio of the pixels binarized with color parameters to the land window is a factor for the judgment. This allows the judgment to be free from the influence of the size of the land window which is varied depending on the displacement or skew of a component.

Although the area condition is related on the one-to-one basis to the color condition and the judgment condition in the embodiments, one area condition may preferably be associated with two or more of the color conditions and the judgment conditions. More particularly, as the area condition R1 is associated with three color conditions C1, C2, and C3 determined by the separation between the object point and the reject point (listed from the largest degree of separation) and with three judgment conditions J1, J2, and J3 relating to their respective color conditions, three combinations (R1, C1, J1), (R1, C2, J2), and (R1, C3, J3) are established. Even if the area condition remains unchanged, the individual judgments may be varied depending on the color condition and the judgment condition if they are varied. Using the different results of the judgment, the final judgment at higher accuracy can be obtained by comprehensive judgment using logic formula. This can also be applied to the application of two or more area conditions in the second to fourth embodiments. For example, when three area conditions are associated with three color conditions and three judgment conditions, nine combinations of the area condition, the color condition, and the judgment condition can be provided.

**Claims**

1. An inspection logic setting method of the PC board inspecting apparatus (1) which is a method for generating the inspection logic for use in a PC board inspecting apparatus (1) arranged to project different colors of light at different incident angles onto a surface mounted component (21) on a board (20), extract an inspection area (73) determined by the predetermined area condition from an image which has been produced from the reflection of color light, pick up an area in the inspection area which satisfies the predetermined color condition, and examine whether or not the picked up area satisfies the predetermined judgment condition for judging the surface mounted state of said component (21), **characterized by** a data processing apparatus arranged to conduct:

   acquiring a plurality of first images of components to be detected by the inspection and a plurality of second images of components to be rejected by the inspection,
   dividing each of said plurality of first and second images into the plurality of blocks,
   calculating a color distance between said plurality of first images and said plurality of second images in said each block,
   selecting one or more blocks from said plurality of blocks which are relatively greater in said color distance, and assigning said selected block (s) to said area condition.

2. An inspection logic setting method of the PC board inspecting apparatus (1) according to claim 1, wherein the data processing apparatus is arranged to conduct:

   extracting from said first image an obj ect image determined by said area condition,
   extracting from said second image a reject image determined by said area condition,
   calculating a frequency distribution of the measurements of one or more color feature values at each of said plurality of object points and the reject points where each pixel in said obj ect image represents obj ect point and each pixel in said reject image represents said reject point,
   calculating based on said frequency distribution of the measurements of one or more color feature values a range of the measurements of said one or more color feature values where the separation between the measurement color feature values at said each object point and the measurement color feature values at said each color feature values reject point is maximum, and
   assigning said type and said range of the measurements of said one or more color feature values to the color condition.

3. An inspection logic setting method of the PC board inspecting apparatus (1) according to claim 2, wherein the type of said color feature values is predetermined.

4. An inspection logic setting method of the PC board inspecting apparatus (1) according to claim 2, wherein said data processing apparatus is arranged to:

   have the plurality of candidates for the color feature values consisting of said one or more color feature values,
   calculate for each of said plurality of candidates for the color feature values a range of the measurements of and the degree of separation between the measurement of the color feature values where the separation between the measurement of the color feature values at said object point and the measurement of the color feature values at said reject point is maximum, and select through the candidates for color feature values which are then employed for determining said color condition comparing the degree of separation, and assign the type and range of the measurements of one or more color feature values constituting said selected candidates of the color feature values to said color condition.

5. An inspection logic setting method of the PC board inspecting apparatus (1) according to any of claims 2 to 4, wherein the data processing apparatus is arranged to conduct:

extracting from each of said object images and said reject images pixel areas which satisfy said color condition, calculating a frequency distribution of the measurements of one or more feature values in each of said pixel areas, calculating based on said frequency distribution of the measurements of said one or more feature values a range of the measurements of the feature values where the separation between the measurement of the feature value in pixel area extracted from said object image and the measurement of the feature value in pixel area extracted from said reject image is maximum, and assigning said type and said range of the measurements of said one or more feature values to said judgment condition.

6. An inspection logic setting method of the PC board inspecting apparatus (1) according to claim 5, wherein the type of said feature values is predetermined.

7. An inspection logic setting method of the PC board inspecting apparatus (1) according to claim 5, wherein the data processing apparatus is arranged to:

have the plurality of candidates for the feature values consisting of one or more feature values, calculate for each of said plurality of candidates for the feature values a range of the measurement of and the degree of separation between the measurement of the feature values where the separation between the measurement of the feature values in pixel area extracted from said obj ect image and the measurement of the feature values in pixel area extracted from said reject image is maximum, and select the candidates for the feature values which are then employed for determining said judgment condition through comparing the degree of separation, and assigning said type and said range of the measurements of one or more feature values constituting said selected candidates of said one or more feature values to said judgment condition.

8. An inspection logic setting method of the PC board inspecting apparatus (1) according to any of claims 5 to 7, wherein said data processing apparatus is arranged to conduct:

producing a plurality of area conditions of different area from said selected blocks, and calculating and determining said color condition and said judgment condition in relation to each of said plurality of area conditions.

9. An inspection logic setting method of the PC board inspecting apparatus (1) according to claim 8, wherein said data processing apparatus is arranged to conduct:

selecting two or more of the blocks which are relatively greater in said color distance, and grouping the selected plurality of blocks on the color distance to determine said plurality of area condition of the different areas.

10. An inspection logic setting method according to any of claims 5 to 9, wherein the data processing apparatus is arrange to conduct:

calculating and determining the plurality of combinations of said color condition and said judgment condition that are different from each other for said area condition.

11. An inspection logic setting method of the PC board inspecting apparatus (1) according to any of claims 5 to 10, wherein the data processing apparatus is arrange to conduct:

determining two or more combinations of logic formulas consisting of said calculated area condition, said color condition, and said judgment condition as the inspection logic for said PC board inspecting apparatus (1) conducting the inspecting action.

**12.** An inspection logic setting method of the PC board inspecting apparatus (1) according to any of claims 1 to 11, wherein said inspection logic is determined for each type of a component (21) to be inspected.

**13.** An inspection logic setting method of the PC board inspecting apparatus (1) according to any of claims 1 to 12, wherein said inspection logic is determined for each type of error.

**14.** An inspection logic setting apparatus (2) of the PC board inspecting apparatus (1) which is a method for generating the inspection logic for use in a PC board inspecting apparatus (1) arranged to project different colors of light at different incident angles onto a surface mounted component (21) on a board (20), extract an inspection area (73) determined by the predetermined area condition from an image which has been produced from the reflection of color light, pick up an area in the inspection area (73) which satisfies the predetermined color condition, and examine whether or not the picked up area satisfies the predetermined judgment condition for judging the surface mounted state of said component (21), **characterized by**:

an image acquiring means (52) for acquiring a plurality of first images of components to be detected by the inspection and a plurality of second images of components to be rejected by the inspection, a color distance calculating means (80) for dividing each of said first and second images into said plurality of blocks and calculating a color distance between said plurality of first images and said plurality of second images in said each block, and an area condition determining means (81) for selecting one or more blocks from said plurality of blocks which are relatively greater in said color distance and assigning said selected block(s) to said area condition.

**15.** An inspection logic setting apparatus (2) of the PC board inspecting apparatus (1) according to claim 14, further comprising:

a means for extracting from said first image an object image determined by said area condition, a means for extracting from said second image a reject image determined by said area condition, a means for calculating a frequency distribution of the measurements of one or more color feature values at each of said plurality of object points and the reject points where each pixel in said object image represents object point and each pixel in said reject image represents reject point, a means for calculating based on said frequency distribution of the measurements of one or more color feature values a range of the measurements of said one or more color feature values where separation between the measurement of the color feature values at said object point and the measurement color feature values at said reject point is maximum, and a means for assigning said type and said range of the measurements of said one or more color feature values to the color condition.

**16.** An inspection logic setting apparatus (2) of the PC board inspecting apparatus (1) according to claim 15, wherein the type of said one or more color feature values is predetermined.

**17.** An inspection logic setting apparatus (2) of the PC board inspecting apparatus (1) according to claim 15, wherein said apparatus (2) is arranged to have the plurality of candidates for the color feature values consisting of said one or more color feature values and conduct:

calculating for each of said plurality of candidates for the color feature values a range of the measurements of and the degree of a separation between the measurement of the color feature values where the separation between the measurement of the color feature values at said object point and the measurement of the color feature values at said reject point is maximum, and selecting the candidates for said color feature values which are then employed for determining said color condition through comparing said degree of separation, and assigning said type and said range of the measurements of one or more color feature values constituting said selected candidates for the color feature values to said color condition.

**18.** An inspection logic setting apparatus (2) of the PC board inspecting apparatus (1) according to any of claims 15 to 17, further comprising:

a means for extracting from each of said object images and said reject images pixel areas which satisfy said color condition, a means for calculating a frequency distribution of the measurements of one or more feature values in each of said plurality of pixel areas,
a means for calculating based on the frequency distribution of the measurements of said one or more feature values a range of the measurements of said the feature values where said separation between the measurement of said feature values in pixel area extracted from said object image and the measurement of said feature values in pixel area extracted from said reject image is maximum, and
a means for assigning the type and the range of said measurements of said one or more feature values to said judgment condition.

19. An inspection logic setting apparatus (2) of the PC board inspecting apparatus (1) according to claim 18, wherein the type of said feature values is predetermined.

20. An inspection logic setting apparatus (2) of the PC board inspecting apparatus (1) according to claim 18, wherein said apparatus (2) is arranged to have the plurality of candidates for the feature values consisting of said one or more feature values and conduct:

calculating for each of said plurality of candidates for the feature values a range of the measurements of and the degree of separation between the measurement of the feature values where said separation the measurement of the feature values in pixel area extracted from said object image and the measurement in pixel area extracted from said reject image is maximum and selecting the candidates for the feature values which are then employed for determining said judgment condition through comparing the degree of separation, and assigning said type and said range of the measurements of one or more feature values constituting said selected candidates for the feature values to said judgment condition.

21. An inspection logic setting apparatus (2) of the PC board inspecting apparatus (1) according to any of claims 18 to 20, wherein
said area condition determining means is arranged to conduct:

producing a plurality of area conditions of different area from said selected blocks, and
calculating and determining said color condition and said judgment condition in relation to each of said plurality of area conditions.

22. An inspection logic setting apparatus (2) of the PC board inspecting apparatus (1) according to claim 21, wherein said area condition determining means is arranged to conduct:

selecting two or more of said blocks which are relatively greater in the color distance, and
grouping said selected plurality of blocks on the color distance to determine said plurality of area conditions of different areas.

23. An inspection logic setting apparatus (2) of the PC board inspecting apparatus (1) according to any of claims 18 to 22, wherein
the plurality of combinations of said color condition and said judgment condition that are different from each other are calculated and determined for said area condition.

24. An inspection logic setting apparatus (2) of the PC board inspecting apparatus (1) according to any of claims 18 to 23, wherein
two or more combination of logic formulas consisting of said calculated area condition, said color condition, and said judgment condition are determined as the inspection logic for said PC board inspecting apparatus (1) conducting the inspecting action.

25. An inspection logic setting apparatus (2) of the PC board inspecting apparatus (1) according to any of claims 14 to 24, wherein
said inspection logic is determined for each type of a component to be inspected.

26. An inspection logic setting apparatus (2) of the PC board inspecting apparatus (1) according to any of claims 14 to 25, wherein
said inspection logic is determined for each type of error.

27. A program for generating an inspection logic for use in a PC board inspecting apparatus (1) which is arranged to project different colors of light at different incident angles onto a surface mounted component (21) on a board (20), extract an inspection area determined by the predetermined area condition from an image which has been produced from the reflection of color light, pick up an area in the inspection area (73) which satisfies the predetermined color condition, and examine whether or not the picked up area satisfies the predetermined judgment condition for judging the surface mounted state of said component (21), said program arranged for instructing a data processing apparatus arranged to conduct the steps of:

acquiring a plurality of first images of components to be detected by the inspection and a plurality of second images of components to be rejected by the inspection,
dividing each of said plurality of first and second images into the plurality of blocks,
calculating a color distance between said plurality of first images and said plurality of second images in said each block,
selecting one or more blocks from said plurality of blocks which are relatively greater in the color distance, and assigning said selected block(s) to the area condition.

**28.** A program according to claim 27, further instructing said data processing apparatus (26) to conduct the steps of:

extracting from said first image an obj ect image determined by said area condition,
extracting from said second image a reject image determined by said area condition,
calculating a frequency distribution of the measurements of one or more color feature values at each of said plurality of the object points and the reject points where each pixel in said object image represents the object point and each pixel in said reject image represents the reject point,
calculating based on said frequency distribution of the measurements of one or more color feature values a range of the measurements of said one or more color feature values where separation between the measurement of the color feature values at said obj ect point and the measurement said color feature values at said reject point is maximum, and
assigning the type and the range of the measurements of said one or more color feature values to the color condition.

**29.** A program according to claim 28, wherein
the type of said one or more color feature values is predetermined.

**30.** A program according to claim 27, wherein
the program is arranged to have the plurality of candidates for the color feature values consisting of said one or more color feature values, and the program further instructs said data processing apparatus to conduct:

calculating for each of said plurality of candidates for the color feature values range of the measurements of and the degree of separation between the measurement of the color feature values where the separation between the measurement of the color feature values at said object point and the measurement of the color feature values at said reject point is maximum, and selecting the candidates for the color feature values which are then employed for determining said color condition through comparing the degree of separation, and
assigning the type and the range of the measurements of one or more color feature values constituting said selected candidates for said the color feature values to said color condition.

**31.** A program according to any of claims 28 to 30, further instructing said data processing apparatus (26) to conduct:

extracting from each of said object images and said reject images pixel areas which satisfy said color condition,
calculating a frequency distribution of the measurements of one or more feature values in each of said plurality of pixel areas,
calculating based on the frequency distribution of the measurements of said one or more feature values a range of the measurements of the feature values where the separation between measurement of the feature value in pixel area extracted from said object image and measurement of the feature value in pixel area extracted from said reject image is maximum, and
assigning the type and the range of the measurements of said one or more feature values to said judgment condition.

**32.** A program according to claim 31, wherein
the type of said one or more feature values is predetermined.

**33.** A program according to claim 31, wherein
the program is arranged to have the plurality of candidates for the feature values consisting of one or more feature values, the program further instructs said data processing apparatus to conduct:

calculating for each of said plurality of candidates for the feature values a range of the measurements of and the degree of separation between the measurement of the feature values where the separation between the measurement of the feature values in pixel area extracted from said obj ect image and the measurement of the feature values in pixel area extracted from said reject image is maximum, and selecting the candidates for said feature values which are then employed for determining said judgment condition through comparing the degree of separation, and
assigning said type and said range of the measurements of one or more feature values constituting said selected candidates for the feature values to said judgment condition.

**34.** A program according to any of claims 31 to 33, wherein
a plurality of area conditions of different area are produced from said selected blocks, and
said color condition and said judgment condition are calculated and determined in relation to each of said plurality of area conditions.

**35.** A program according to claim 34, wherein
two or more of said blocks which are relatively greater in the color distance are selected, and
said selected plurality of blocks are grouped on the color distance to determine said plurality of area condition of different areas.

**36.** A program according to any of claims 31 to 35, wherein
plurality of combinations of said color condition and said judgment condition that are different from each other are calculated and determined for said area condition.

**37.** A program according to any of claims 31 to 36, further instructing the data processing apparatus to conduct the step of:

determining two or more combination of logic formulas consisting of said calculated area condition, said color condition, said the judgment condition as the inspection logic for said PC board inspecting apparatus (1) conducting the inspecting action.

**38.** A program according to any of claims 27 to 37, wherein
said inspection logic is determined for each type of a component to be inspected.

**39.** A program according to any of claims 27 to 38, wherein said inspection logic is determined for each type of error.

**40.** A storage medium for saving the program defined in any of claims 27 to 39.

**41.** A PC board inspecting apparatus (1) comprising:

a storage (34) for saving the area condition, the color condition, and the judgment condition which have been determined by said inspection logic setting method defined in any of claims 1 to 13,
aprojectingmeans forprojectingdifferent colors of light at different incident angles onto a surface mounted component (21) on a board (20),
an area extracting means for extracting an inspection area determined by said area condition from an image which has been produced from the reflection of color light and picking up an area in the inspection area which satisfies said color condition, and
a judging means for examining whether or not the picked up area satisfies said judgment condition for judging the surface mounted state of said component (21).

**42.** A PC board inspecting apparatus (1) comprising:

a storage (35) for saving different combinations of the area condition, the color condition, and the judgment condition, which have been determined by said inspection logic setting method defined in claim 11, and a set of logic formulas for calculating the different combinations,
aprojectingmeans forprojectingdifferent colors of light at different incident angles onto a surface mounted component (21) on a board (20),

an area extracting means (81) for extracting inspection areas determined by the area conditions in said each combination from an image which has been produced from the reflection of color light and picking up an area in each of the inspection areas which satisfies said corresponding color condition, and

a judging means for examining and judging separately whether or not each picked up area in said inspection area (73) satisfies said corresponding judgment condition and determining a final judgment for the surface mounted state of the component (21) by assigning these individual judgment results to said logic formulas.

Fig .1

Fig .2

CAD data storage ~32a

Command data receiving function (10)

CAD data reading function (12)

External device/entry unit

Board loading function (11)

Stage operating function (13)

Board unloading function (18)

PC board unloader

Electronic components surface mounted PC board loader

Imaging function (14)

Inspecting function (16)

Judgment writing function (17)

Inspection logic reading function (15)

Judgment storage ~32b

Inspection logic storage ~35

EP 1 679 520 A1

Fig. 3

Side view

Imaging
pattern
(upper view)

Good board

Not good board
(wetting error)

25

Fig. 4

START

S101
Other process

S100
Is command data for conducting board inspection received?
N

S102
Load PC board in response to command data

S103
Read CAD data of board type from storage

S104
Read inspection logic for components from storage

S105
Operate XY stage corresponding to CAD data

S106
Produce image of PC board in synchronization with movement of stage

S107
Extract soldering area from image

S108
Binarize extracted soldering area on color condition

S109
Is surface measure of white pixels higher than threshold?
N

S110
Judge as good board

S111
Judge as not good board

S112
Save judgment with location ID in storage

S113
Unload PC board by PC board unloader

END

Fig. 5

Red color area   73 Inspection area   72 Land area

Green color area

Blue color area

Binarizing

Good board image

Red color area   73 Inspection area   72 Land area

Green color area

Blue color area

Binarizing

Not good board image

Fig .6

Data entry unit → Command data receiving function (50)

Teaching image data DB (61) → Teaching image data reading function (51)

Image acquiring function (52)

Sorting function (53)

Color distance calculating function (80) → Inspection area determining function (81)

Frequency calculating function (54)

Color range searching function (55)

Binarizing function (56)

Feature value histogram generating function (57)

Threshold determining function (58)

Inspection logic generating function (59)

Inspection logic writing function (60)

Inspection logic storage (35)

EP 1 679 520 A1

28

Fig. 7

START

S201
Other process

S200
Is command data for automatically generating inspection logic received?  →N

S202
Read teaching image data for inspection logic to be generated from DB in response to command data

S203
Extract land area assigned with teaching data from teaching image data

S204
Sort land area into good board image and not good board image in reference to teaching data

S205
Divide image into blocks and calculate color distance in each block

S206
Assign color distance greatest block to area condition

S207
Calculate frequency distribution of color feature value of full pixels in each of object image and reject image

S208
Search color range for separating between object point and reject point, and assign it to color condition

S209
Binarize all inspection areas on color condition

S210
Generate surface measure histogram of binarized white pixels in each of good and not good images

S211
Calculate from generated surface measure histogram threshold for separating between good and not good

S212
Generate inspection logic

S213
Save inspection logic in storage

END

EP 1 679 520 A1

Fig. 8

Good board image

Not good board image

30

Fig. 9

Template

Fig. 10

Fig. 11

Fig. 12

A

255

LSup

Brightness

LInf

0     BInf     BSup     255

B signal intensity

B

255

Brightness

LSup

Maximum of frequency sum E

LInf

0     BInf     BSup     255

B signal intensity

EP 1 679 520 A1

Fig .13

Surface measure histogram of not good board

Frequency

Surface measure histogram of good board

Frequency

Surface measure

Surface measure

Frequency

Threshold

Surface measure

Fig .14

Typical good board A → Binarizing → Judgment → Good

Good board B exhibiting red area → Binarizing → Judgment → Not good (over-detection)

Not good board C with wetting error → Binarizing → Judgment → Not good

EP 1 679 520 A1

Fig. 15

```
                    ┌──────────────┐
                    │    START     │
                    └──────────────┘
                                              S201
                            │        ┌──────────┐
                            │        │  Other   │
                     S200   ▼        │ process  │
                        ╱───────────╲└──────────┘
                       ╱ Is command  ╲
                      ╱ data for      ╲  N
                     ╱ automatically   ╲──────►
                      ╲ generating     ╱
                       ╲inspection     ╱
                        ╲ logic       ╱
                         ╲received?   ╱
                          ╲─────────╱
                     S202     │ Y
                            ▼
                ┌──────────────────────┐
                │ Read teaching image  │
                │ data for inspection  │
                │ logic to be generated│
                │ from DB in response  │
                │ to command data      │
                └──────────────────────┘
                     S203    │
                            ▼
                ┌──────────────────────┐
                │ Extract land area    │
                │ assigned with        │
                │ teaching data from   │
                │ teaching image data  │
                └──────────────────────┘
                     S204    │
                            ▼
                ┌──────────────────────┐
                │ Sort land area into  │
                │ good board image and │
                │ not good board image │
                │ with reference to    │
                │ teaching data        │
                └──────────────────────┘
                     S205    │
                            ▼
                ┌──────────────────────┐
                │ Divide image into    │
                │ blocks and calculate │
                │ color distance in    │
                │ each block           │
                └──────────────────────┘
                     S300    │
                            ▼
                ┌──────────────────────┐
                │ Select color distance│
                │ greatest block       │
                └──────────────────────┘
                     S301    │
                            ▼
                ┌──────────────────────┐
                │  Assign area         │
                │  condition           │
                └──────────────────────┘
```

Repeat for each area condition

S207 — Calculate frequency distribution of color feature value of all pixels in each of object image and reject image

S208 — Search color range for separating between object point and reject point, and assign it to color condition

S209 — Binarize all inspection area on color condition

S210 — Generate surface measure histogram of binarized white pixels in each of good and not good images

S211 — Calculate from generated surface measure histogram threshold for separating between good and not good

S212 — Generate inspection logic

S213 — Save inspection logic in storage

END

Fig. 16

START

S400
Calculate color distance
in each block

S401
Calculate absolute of
color distance in blocks

S402
Are pair of blocks of which
color distance difference is
smaller than constant k
found?

N

Y

S403
Group
blocks

S404
Are remaining blocks
greater than one?

Y

N

S405
Assign remaining block
to area condition

END

Fig .17

**Typical good board A**

Area condition2 · Area condition1

Binarizing → Individual judgment → Area 1: good / Area 2: good → Final judgment → Good

**Good board B exhibiting red area**

Binarizing → Individual judgment → Area 1: not good / Area 2: good → Final judgment → Good

**Not good board C with wetting error**

Binarizing → Individual judgment → Area 1: not good / Area 2: not good → Final judgment → Not good

EP 1 679 520 A1

Fig .18

Typical good board A → Binarizing → Area condition1 / Area condition2 → Individual judgment → Area 1: good / Area 2: good → Final judgment → Good

Not good board . D exhibiting blue area → Binarizing → Individual judgment → Area 1: not good / Area 2: good → Final judgment → Not Good

Typical not good board C → Binarizing → Individual judgment → Area 1: not good / Area 2: not good → Final judgment → Not Good

EP 1 679 520 A1

Fig .19

Fig. 20

Fig. 21

| | Good soldering | Component missing | Short soldering |
|---|---|---|---|
| Cross-sectional view | | | |
| Imaging pattern | | | |
| Red pattern | | | |
| Green pattern | | | |
| Blue pattern | | | |

Fig. 22

Fig. 23

Not good
board
exhibiting red
area at

Not good
board
exhibiting red
area at

Not good
board
exhibiting red
area at right
end of land

**European Patent Office**

## EUROPEAN SEARCH REPORT

Application Number

EP 06 10 0242

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 023 663 A (KIM ET AL) 8 February 2000 (2000-02-08) | 41,42 | INV. G01R31/04 G01N21/956 |
| A | * column 2, line 23 - column 5, line 36; claim 1; figures 1,2,4,7 * ----- | 1-40 | |
| A | DRIELS M R ET AL: "AUTOMATIC DEFECT CLASSIFICATION OF PRINTED WIRING BOARD SOLDER JOINTS" IEEE TRANSACTIONS ON COMPONENTS,HYBRIDS,AND MANUFACTURING TECHNOLOGY, IEEE INC. NEW YORK, US, vol. 13, no. 2, 1 June 1990 (1990-06-01), pages 331-340, XP000179243 ISSN: 0148-6411 * the whole document * ----- | 1-42 | |
| A | US 6 404 206 B1 (SPERSCHNEIDER ECKHARD) 11 June 2002 (2002-06-11) * column 2, line 28 - line 42 * ----- | 1-42 | |

TECHNICAL FIELDS SEARCHED (IPC)

G01R
G01N

The present search report has been drawn up for all claims

| Place of search | Date of completion of the search | Examiner |
|---|---|---|
| The Hague | 28 April 2006 | Koll, H |

EPO FORM 1503 03.82 (P04C01)

**EP 1 679 520 A1**

**ANNEX TO THE EUROPEAN SEARCH REPORT
ON EUROPEAN PATENT APPLICATION NO.**

EP 06 10 0242

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2006

| Patent document cited in search report | | Publication date | Patent family member(s) | | Publication date |
|---|---|---|---|---|---|
| US 6023663 | A | 08-02-2000 | JP | 9275272 A | 21-10-1997 |
| | | | KR | 200215 B1 | 15-06-1999 |
| US 6404206 | B1 | 11-06-2002 | AT | 246803 T | 15-08-2003 |
| | | | CA | 2289721 A1 | 12-11-1998 |
| | | | DE | 29823250 U1 | 29-04-1999 |
| | | | WO | 9850784 A1 | 12-11-1998 |
| | | | EP | 0980520 A1 | 23-02-2000 |

EPO FORM P0459

For more details about this annex : see Official Journal of the European Patent Office, No. 12/82